# EUROPEAN PATENT SPECIFICATION

(11) **EP 3 345 178 B1**
(45) Date of publication and mention of the grant of the patent: **10.03.2021**
(21) Application number: 16778087.3
(22) Date of filing: 02.09.2016
(51) Int. Cl.: G09G 3/00, H01L 25/075

(54) **ASSEMBLY OF SEMICONDUCTOR DEVICES**
MONTAGE VON HALBLEITERBAUELEMENTEN
ENSEMBLE DE DISPOSITIFS À SEMI-CONDUCTEURS

(30) Priority: 02.09.2015 GB 201515564; 17.11.2015 GB 201520265; 26.04.2016 GB 201607248; 27.05.2016 GB 201609422
(43) Date of publication of application: 11.07.2018
(60) Divisional application: 18188965.0
(73) Proprietor: Facebook Technologies, LLC, Menlo Park, CA 94025 (US)
(72) Inventor: HUGHES, Padraig, Berrings County Cork (IE); O'KEEFFE, Joseph, Fermoy County Cork (IE); OYER, Celine, County Cork (IE); HENRY, William, County Cork (IE); MASSOUBRE, David, County Cork (IE); SAKETI, Pooya, 33230 Tampere (FI)
(74) Representative: Murgitroyd & Company
(86) International application number: PCT/GB2016/052722
(87) International publication number: WO 2017/037475

(56) References cited:
- US-A1- 2003 011 377
- US-A1- 2014 267 683
- US-B1- 8 426 227

## Description

### Technical Field

The invention relates to methods and apparatus for assembling semiconductor devices, LED dies for display technologies, displays and methods of manufacture for displays. Specifically, the invention is related to, but need not be limited to, Inorganic Light Emitting Diode (ILED), micro-LED (µLED) dies for display technologies, µLED displays and/or methods of manufacture for µLED displays. The invention may relate to methods and apparatus for assembling semiconductor devices by contact printing.

### Background

Displays are ubiquitous and are a core component of wearable devices, smart phones, tablets, laptops, desktops, TVs and display systems. Common display technologies today range from Liquid Crystal Displays (LCDs) to more recent Organic Light Emitting Diode (OLED) Displays and Active Matrix Organic Light Emitting Diode Displays (AMOLEDs).

The display architectures include passive and active matrix displays depending on whether each pixel is driven separately or not. Active drive circuitry uses thin film transistor (TFT) technology where transistors based on amorphous silicon (A -Si), low temperature polysilicon (LTPS) and amorphous Indium Gallium Zinc Oxide (IGZO) technology are manufactured on glass panels which may have glass substrate sizes from first generation displays of around 30 cm x 40 cm to the latest tenth generation displays (known as GEN 10) of around 2.88 m x 3.15m.

In most portable devices (i.e. battery powered devices) the display uses a majority of the available battery power. Additionally, the most common user complaint for portable devices is insufficient display brightness. To extend battery life and improve brightness levels it is necessary to develop new display technologies that reduce power consumption and produce higher luminance emission from the light source.

Inorganic LEDs (ILEDs) are emerging as the third generation of flat display image generators based on superior battery performance and enhanced brightness. The ILED Display is at a basic level a variation of the OLED (organic LED) display. The OLED concept is based on passing current through organic or polymer materials that is sandwiched between two glass planes to produce light. The proposed ILED Display concept essentially replaces the organic LED material with a discrete standard LED (which is made of inorganic materials) at each pixel of the display (each pixel consists of three individual Red, Green and Blue LEDs for colour displays).

Standard (i.e. inorganic) LED devices have been around for many years and their performance (efficiency, brightness, reliability and lifetime) has been optimised over many years as the LED industry has pursued many commercial opportunities - especially the challenge of developing LED technology to enable it to replace the standard incandescent bulbs for general light applications, i.e. inorganic LEDs are significantly more efficient, bright and reliable than the new and less developed OLED materials.

The concept of individually switchable standard LEDs (R, G & B) at each pixel in a display is well known. This approach is in widespread use for large information displays. However, to-date it has not been possible to scale this approach down to smaller displays as standard LEDs are typically planar chips which are inefficient for light direction control. Additionally, the assembly of the many millions of pixels needed for a laptop or smart phone display is not feasible at this scale using traditional assembly manufacturing techniques.

The current challenges with ILED display manufacture are significant and assembly techniques to overcome wafer yields losses need to be factored in to the manufacturing strategy of ILED displays for today's yields and higher anticipated yields in the future. Selective pick up tools (PUTs) is one solution to overcoming yield problems where defective die are identified and replaced at source. Depending on the yield, it may not be practical or economical either to replace known bad die or to transfer only KGD from a wafer to a temporary carrier for pick to the TFT substrate. Both approaches require wafer level testing to determine KGD or defective chips on the wafer, which is complicated.

Smart assembly processes with resolutions to manipulate and handle small die improve ILED assembly on the glass panel. There is therefore a need for an assembly process with high throughput that can enable massive parallel pick and transfer of ILED dies of size < 10µm a side from the native LED wafer onto a glass TFT substrate at accuracies approx. ±3µm or less.

Smart assembly methods are being developed in the industry for ILED displays and range from "non selective" elastomer conformal stamps, laser assisted transfer, direct self-assembly methods, fluidic assembly and selective MEMs based printheads. All techniques require the preparation of assembly ready chips where the bulk of the substrate is removed or the epilayer released from the substrate. For ILED displays to become a commercial reality, many or all of the above challenges need to be solved.

US 2003/0011377 A1 discloses a device mounting substrate and method of repairing a defective device. The document discloses forming the light emitting diodes into a resin covered chip. Forming an insulation layer to cover the light emitting diode and afterwards forming a wiring, after ending the wiring step, performing a wiring step. A defective pixel may be afterwards repaired by additionally mount a new resin-covered chip for repair without removal of the resin -covered chip in which a defective light emitting diode is buried.

US 2014/0267683 A1 discloses a method of fabricating a light emitting diode display with integrated defect detection test. A plurality of micro LED devices can be transferred to the display substrate adjacent the plurality of irregularities to forming the passivation layer material.

US 8,426,227,B1 discloses a method of forming a micro light emitting diode array. The micro LED structure and the micro LED array may be picked up and transferred to a receiving substrate.

### Summary

According to the invention in an aspect, there is provided a method for manufacturing a display element comprising a plurality of pixels, each pixel comprising a plurality of sub- pixels, each sub-pixel being configured to provide light of a given wavelength, the method comprising: undertaking, using a pick up tool, PUT, a first placement cycle comprising picking up a plurality of first, untested LED dies, each first LED die comprising at least one first LED emitter configured to provide one of the plurality of sub-pixels of the display, and placing the first LED dies on a display substrate at locations corresponding to the plurality of pixels of the display; testing the first LED emitters on the display substrate to determine one or more locations of non-functional first LED emitters; from a plurality of second, tested LED dies each comprising at least one second LED emitter configured to provide one of the plurality of sub-pixels of the display, selecting one or more second LED dies based on a result of the test; configuring the selected one or more second LED dies to enable their pick up and placement on the display substrate; and undertaking, using the PUT, a second placement cycle comprising picking up the selected one or more second LED dies and placing the selected one or more second LED dies on the display substrate at the determined locations of the non-functional first LED emitters.

Untested LED dies encompass LED dies that have not been tested on the wafer during or after fabrication. Untested LED dies may not have any test data associated with them and giving an indication of their operability, save for information relating to wafer yield, wafer material quality and/or the like. Tested LED dies encompass dies that have been tested to determine their operability. Tested LED dies may be those dies that have been tested after fabrication, perhaps on the wafer, and that have been determined to be operable. These LED dies may also be termed Known Good Dies, KGD.

It is noted that not all LED dies will be testable on the display substrate without further display fabrication steps being undertaken. For example, a vertical LED device, which has electrodes on two opposed surfaces thereof, needs further a metallisation step of the display fabrication process before it can be fully tested, e.g. for short circuit. This makes the second placement cycle much more complicated, if not impossible.

It is also noted that in exemplary methods, the non-functioning first LED dies are not replaced by the second placement cycle. Rather, in exemplary methods, the second LED dies are placed at the pixel location in addition to the non-functioning first LED dies.

Optionally, the step of configuring the selected one or more LED dies comprises depositing a deformable material on the one or more selected second LED dies.

Optionally, the deformable material is configured to cause adhesion between the one or more selected second LED dies and the PUT during the second placement cycle. Adhesion may encompass van der Waal forces due to the deformability (or conformability) of the deformable material.

Optionally, the method the step of depositing the deformable material on the one or more selected second LED dies comprises applying the deformable material to a mould or carrier element and engaging the mould or carrier with a surface of one or more of the plurality of second LED dies so that the deformable material is in contact with the surface of the one or more of the plurality of second LED dies.

Optionally, depositing the deformable material on the one or more selected second LED dies comprises modifying a level of adhesion between the deformable material and the one or more selected second LED dies so that the deformable material adheres to the one or more selected LED dies.

Optionally, the step of modifying the level of adhesion between the deformable material and the one or more selected second LED dies comprises irradiating with light one or more portions of the mould or carrier element corresponding to locations of the one or more selected second LED dies. Optionally, the light comprises ultraviolet light.

Optionally, prior to depositing the deformable layer on the one or more selected second LED dies, the method comprises placing the selected second LED dies on a handle layer. Optionally, the selected second LED dies are adhered to the handle layer.

Optionally, the second placement cycle comprises modifying a level of adhesion between one or more of the selected second LED dies and the handle layer, such that the level of adhesion is less than a force applied by the PUT.

Optionally, the method comprises depositing a deformable material on the plurality of first LED dies, prior to undertaking the first placement cycle.

Optionally, the deformable material is configured to cause adhesion between the plurality of first LED dies and the PUT during the first placement cycle.

Optionally, the method further comprises undertaking a further test of the first LED emitters and/or the second LED emitters after the second placement cycle to determine locations of one or more non-functional first and/or second LED emitters.

Optionally, the method further comprises selecting one or more third, tested LED dies after undertaking the further test, based on a result of the further test.

Optionally, the test and/or the further test comprises applying a reverse bias to the first and/or the second LED emitters and/or applying a forward bias to the first and/or second emitters and using one or more filter(s) to analyse the emission from the first and/or second LED emitters.

Optionally, the method further comprises undertaking one or more calibration cycles of an assembled display based on the results of the test and/or the further test.

Optionally, the one or more calibration cycles comprise disconnecting one or more non-functional first and/or second LED emitters from a drive circuitry on the display substrate.

Optionally, the method further comprises depositing an underfill or non-conductive film on the substrate of the display, prior to the first and/or second placement cycles.

Optionally, the method further comprises modifying a viscosity of the underfill or non-conductive film to enable pre-bonding or bonding of the first and selected second one or more LED dies to the display substrate.

Optionally, the first and/or second LED dies comprise a bonding element arranged to permit interconnection of the first and/or second LED dies to the display substrate.

Optionally, the bonding element is configured to form a temporary contact with an electrical contact of the display substrate, thereby allowing testing of the first and/or second LED dies.

Optionally, the method comprises bonding the first and/or selected one or more second LED dies to the display substrate using a bonding head.

Optionally, the bonding head comprises a drum configured to move across the display substrate of the display and apply a force to the first and/or selected one or more second LED dies positioned thereon.

Optionally, the PUT is a non-selective PUT.

Optionally, the first and second LED dies comprise µLED dies comprising one or more respective µLED emitters.

Optionally, each µLED emitter comprises first and second electrodes configured to allow current to pass through the µLED emitter, and wherein the first and second electrodes are positioned on the same surface of the µLED die.

Optionally, the first and second electrodes are positioned on a surface of the µLED die opposite an emission surface.

Optionally, the µLED dies comprise a plurality of µLED emitters, each configured to emit light of substantially the same wavelength.

Optionally, one of the first and second electrodes is common to each of the plurality of µLED emitters.

Optionally, the method may further comprise one or more further placement cycles comprising picking up a plurality of display elements, such as passive electronics and/or drive electronics, and placing the display elements at appropriate locations for display manufacture.

According to the invention in an aspect, there is provided a computer program comprising instructions, which when executed on at least one processor, cause the at least one processor to carry out any one of the methods discussed above.

According to the invention in an aspect, there is provided a carrier containing the computer program above, wherein the carrier is one of an electronic signal, optical signal, radio signal or non-transitory computer readable storage medium.

As used herein, the term LED is considered to encompass an ILED. Further, the term LED is considered to encompass a µLED, which may also be an ILED.

It is noted that methods and apparatus disclosed herein relate to LEDs and display manufacture, although they may also relate to photodetector manufacture. In such methods, the term "LED" may be replaced with "photo-sensor". Further, other elements relating to display and/or detector manufacture, such as passive electronics and/or drive electronics, may also be placed in additional placement cycles.

Exemplary methods disclosed herein may comprise a method for assembling LEDs on the top of a non-native substrate to form an LED Display. LED displays may comprise ILEDs, which may be µLEDs. The methods disclosed herein may be tailored according to the known yield constraints appreciated by the industry from both wafer yield losses and in-assembly losses.

Exemplary methods disclosed herein may comprise a combination of non-selective and selective assembly methods using a non-conformal and/or non-selective pick-up tool.

As used herein, the term Pick up Tool (PUT) encompasses a tool containing a single pick-up head or multiple pick-up heads. Each head may be designed to pick at least one LED die (for example, a µLED or ILED) from a handle layer (also termed a handle carrier substrate) and place the LED die onto a final substrate, for example a display substrate such as a TFT. This may require LED dies to be manufactured in an assembly ready format. This may require the removal of the bulk substrate from the LED dies. Exemplary methods for removing the bulk substrate may include Laser Lift-Off (LLO) for sapphire substrates and/or Etch Stop Layer (ESL) dry/wet etching methods for GaAs substrates.

A selective PUT may be a tool containing a single pick-up head or multiple pick-up heads. Each head is individually controllable such that it can be enabled or disabled to pick at least one LED die from a handle carrier substrate selectively. That is, the amount of adherence applied by a selective PUT may be altered, whereby if the pick-up head is enabled then the LED die is picked up, and if the pick-up head is disabled then the LED die is not picked up. The selective PUT may then be configured to place a picked LED die onto a final substrate such as a TFT. A selective PUT may therefore be considered to be programmable depending on the pick-up requirements and is considered an active PUT.

A non-selective PUT may be a tool containing a single pick-up head or multiple pick-up heads. The non-selective PUT may be configured to apply a fixed level of adherence to any given LED die. The level of adherence may not be changed. A non-selective PUT may be designed to pick according to a predetermined pattern or sequence. Each head of a non-selective PUT therefore cannot be individually enabled or disabled to pick a single LED die from a handle carrier substrate and place the LED die onto a final substrate such as a TFT. A non-selective PUT may therefore be considered as non-programmable and is considered a passive PUT.

An ILED display manufacturing approach comprises two features:
1) a spatial map across the wafer (or handle carrier substrate) of Known Good Die (KGD) from a high yielding wafer, which requires wafer level testing prior to assembly; and
2) a selective PUT to pick and place KGD.

The inventors have appreciated that for an LED (in particular an ILED) display manufacture method, the combination of KGD testing at wafer source coupled with a selective PUT is a significant challenge and not readily achieved. The wafer testing may make this approach economically impractical. Alternative strategies are desirable.

Exemplary assembly or microassembly methods may be carried out by attaching a transfer device directly to the PUT head. The transfer device may enable the selectivity necessary to pick KGD for microassembly.

The combination of the PUT and the transfer device may contact the LED die for the pick and the placement of the LED die on the TFT substrate. Examples of transfer devices may comprise conformal transfer devices and/or electrostatic transfer devices. In both cases the transfer device is removed from the element after placement.

Exemplary methods disclosed herein may have a fine resolution to manipulate and handle small dies and may achieve a high throughput. This may enable, for example, massive parallel pick and transfer of ILED dies of sizes < 10µm a side from the native LED wafer onto a glass TFT substrate at accuracies approx. ±2µm or less.

In exemplary methods disclosed herein a deformable material (forming an intermediate layer) may be deposited on a surface of one or more ILED dies, and a head of a non- conformal pick-up tool (PUT) may be used to contact the deposited deformable material. The upper surface of the intermediate layer contacts the PUT and may cause the ILED dies to adhere to the PUT head through the intermediate layer. The PUT, with a plurality of ILED dies adhered to its head, may direct the chips to a desired position over a glass or plastics thin film transistor panel substrate. Then, the upper surface of intermediate layer may be released from the PUT head so that the intermediate layer and ILED dies remain appropriately located on the receiving substrate. The PUT may be non-conformable. The intermediate layer may be deformable such that it is able to make conformal contact with the ILED dies. The intermediate layer on the ILED dies may enable selection of particular ILED dies, such as selection between defective ILED dies and KGD.

Disclosed herein are methods of LED (in particular ILED) display manufacture. The methods may lead to yield improvement based on LED emitter redundancy schemes that take into consideration realistic LED wafer starting yields. The methods may include the combination of non-selective and/or selective processes for pick and place assembly cycles.

For the remainder of this document the exemplary arrangement of µLED dies and are ILEDs is used to describe methods and apparatus for display manufacture. However, it is noted that the principles herein may be applied to other types of LED.

The methods disclosed herein may include multiple assembly cycles (e.g. pick, place & test) combined with multiple µLED dies per colour per display pixel. Each µLED die may contain multiple µLED emitters to give the same effect as a starting wafer material of high device yield, thereby giving higher display yield. It is noted that a wafer's device yield relates to the number of functional devices that a wafer may produce and can be affected by a number of factors, such as wafer quality and fabrication methods.

Display yield encompasses a measure of the number of functional LED emitters or µLED emitters in a display.

In exemplary methods, a single assembly station, or alternatively multiple assembly substations, may undertake first assembly cycle (cycle A) (e.g. pick, place & test) as follows:
- The µLED dies from a wafer containing untested µLED dies (Die Type A) may be deployed;
- The µLED dies from the wafer containing untested µLED dies may be post processed to a microassembly readiness state and may be mounted on a temporary handle layer for pick and place;
- one or more of the µLED dice may have a deformable material, which may form an intermediate transfer layer, applied thereto when mounted on the temporary handle layer;
- A transfer printing non-selective and non-conformal PUT may pick an array of µLED dies from a handle layer. The array of µLED dies may be placed on a display substrate starting, for example, at one corner, and each die corresponding to a pixel location of the display;
- This sequence may be repeated with the pick location on the handle layer moving sequentially to the next (e.g. adjacent) array of µLED dies and a placement location moving to the next (e.g. adjacent) corresponding set of pixel locations on the substrate - the next square in 'a chess board pattern', by way of analogy, wherein each 'square' comprises an array of µLED dies;
- Each µLED die in each array comprises at least one µLED emitter to provide a sub-pixel of a pixel of the display;
- Once the sequence has moved through all the squares in the chess board pattern for one sub-pixel type (i.e. emission colour - RGB), the same process is repeated for the other two sub-pixel types;
- Once all sub-pixel types are completed, a test sequence may be undertaken (e.g. all µLED dies are turned on and functionally tested and it is determined which µLED dies and/or emitters in which pixel locations are not working);
- The test sequence may undertake a screening of dies using filters to tag and identify one or more die(s) that are outside the parametric performance acceptance limits of the display.
- A defect map may be recorded and programmed into the display memory for calibration during a calibration cycle (Cycle C).

In exemplary methods, a single assembly station, or alternatively multiple assembly substations may undertake a second assembly cycle (cycle B1) (e.g. pick, place & test) as follows:
- The µLED dies from a wafer containing untested µLED dies or tested µLED dies, such as KGD, (Die Type B) may be deployed;
- The µLED dies from wafer containing untested µLED dies or tested µLED dies may be post processed to a microassembly readiness state and may be mounted on a temporary handle layer for pick and place;
- The µLED dies may have a deformable material, which may form an intermediate transfer layer, applied to one or more untested or tested µLED dies when mounted on the temporary handle layer;
- The deformable material may be selectively applied to a wafer of untested or tested µLED dies according to the defect map identified during the test in of the first assembly cycle;
- A transfer printing non-selectable and non-conformal PUT may pick an array of µLED dies from a handle layer containing the untested or tested LED dies. The array of µLED dies may correspond to the pixel locations where non-functioning µLED dies are located after the first placement cycle. The array of µLED dies may be placed on a display substrate starting, for example, at one corner;
- Only µLED dies including an intermediate layer may be picked by the PUT;
- This sequence is repeated with the pick location on the handle layer moving sequentially to the next (e.g. adjacent) array of µLED dies and a placement location moving to the next (e.g. adjacent) set of locations on the substrate - the next square in 'a chess board pattern', by way of analogy;
- Once the sequence has moved through all the squares in the chess board pattern for one sub-pixel type, the same process may be repeated for the other two sub-pixel types;
- Once all sub-pixel types are completed, a test sequence may be undertaken (i.e. all µLED dies are turned on and functionally tested and it is determined which µLED dies and/or emitters in which pixel locations are not working);
- The test sequence may undertake a screening of die using filters to tag and identify die which are outside the parametric performance acceptance limits of the display.
- A defect map may be recorded and programmed into the display memory for calibration during a calibration cycle (Cycle C).

In exemplary methods, a single assembly station or an alternative assembly station may undertake a third assembly cycle (Cycle B2), which may be the same as the second assembly cycle (Cycle B1) other than the selection map for µLED pick may generated from the defective map which was determined during the second assembly cycle (Cycle B1). As many subsequent cycles may be undertaken as necessary to achieve a desired display yield.

Exemplary methods may be based on a redundancy model and not on any physical wafer repair strategy. Alternatively, redundancy strategies may comprise placement of a sister µLED sub-pixel adjacent to a defective sub-pixel. A laser trim function may be deployed to open or melt fuses to disconnect the first µLED from the driving circuit. This physical approach to correcting defective sub-pixels while attractive may not be economical in scale when the LED wafer yields are <99%. For example a 90% wafer yield would incur ∼31K laser trim functions after the first assembly cycle, which may be uneconomical. In addition, a second sub-pixel alone may be insufficient for correction unless the assembly yield for the second placement cycle is guaranteed to be 100%.

Exemplary methods may comprise a calibration cycle (Cycle C) of the final display based on the defective maps generated during the assembly sequence (cycles A, B1 and optionally B2). The calibration cycle may comprise a laser trim function to isolate from the drive circuitry defective sub-pixels that were identified in the placement cycles leaving the working µLED sub-pixels placed during the placement cycles still connected to the drive circuitry. Electrical repair strategies may be used to isolate from the drive circuitry defective µLED dies identified after the first placement cycle.

Exemplary methods may comprise one or more of the following features:
- The overall target for the µLED wafer yield may be known
- The multiple µLED dies per colour per display pixel may be sourced from different locations of the same wafer or from different wafers
- The sequence of pick, place & test may be repeated until there is a working µLED die of each colour (R, G and B) in all or nearly all (e.g. 99% or more) or all of the display pixel locations.
- The µLED dies may have all contacts on the same side, and the contacts may be placed down onto the glass, enabling the µLED emitters of each µLED die to be powered from the glass substrate immediately after placement.
- The methods may be used where the µLED wafer has not been previously tested and a defined number of µLED (single emitter or multi emitter LED) dies are placed per colour per pixel.

When a µLED die comprises multiple emitters instead of a single emitter, modelling shows that such multiple emitter dies can significantly reduce the number of cycles/dies required per pixel to obtain an acceptable display yield. This can have a significant impact on wafer material used (number of dies required) and assembly time (number of assembly cycles).

Exemplary methods of the test sequence may comprise one or more of the following features:
- Once all sub-pixel types are completed or between each sub-pixel type placement sequence, the µLED die may pre-bonded or final bond in order to carry out in-line panel testing between cycles. A pre-bond state may be a temporary metal to metal contact between the contacts of the µLED die and contact pads on the substrate of the display. This may not be a permanent bond but may be sufficient to allow testing to occur. A final bond may be where the contacts of the µLED die have undergone, for example, reflow (e.g. eutectic) or metallic interdiffusion e.g. Solid Liquid Intediffiusion (SLID) to create a permanent contact. This may involve an excitation source, such as thermal, compression or ultrasonic forces, to ensure a reliable permanent bond.
- To aid with the pick and place cycle and also the quality of the interconnection pre-applied underfills or post applied underfills may be applied to ensure a good quality reliable bonding interface. A pre-applied underfill may help with the release of the PUT from the intermediate layer and/or the contacts of the µLED die during placement.

Exemplary methods for the deposition of the deformable material to the µLED used in the first assembly cycle (Cycle A) may include one or more of the following: Spin coating and lithography, spray coating, microcontact printing, lamination and micromoulding.

Exemplary methods for the deposition of the deformable material to the µLED used in the second or third assembly cycle (Cycle B1 or B2) may include one or more of the following: Inkjet processing and micromoulding.

Exemplary methods for the application of underfill to the µLED used in the first assembly cycle (Cycle A) may include one or more of the following: Spin coating and lithography, micromoulding and microprinting.

In exemplary methods an underfill may be applied during bonding. The underfill may comprise a pre-applied B-stage epoxy.

In exemplary methods a thermocompression bonding process, e.g. C2, may be used. The bonding process may use CuSn to Cu or Cu to Cu ultra-fine pitch microbump technology.

Exemplary methods may comprise a hybrid assembly method, which may overcome the constraints and challenges of the current technology. Exemplary methods may comprise a sequence of assembly cycles. The sequence of assembly cycles may comprise non-selective and/or selective assembly cycles. The sequence of assembly cycles may comprise a wafer test and/or an in-line panel test. This approach may be enabled by LED dies disclosed herein, which may allow for in-line testing during assembly.

Methods may comprise a first placement cycle (Cycle A). The first placement cycle may part of the non-selective assembly cycle and/or may use LED dies which have not been tested, e.g. individually tested, at wafer level.

Methods may comprise a second and/or third placement cycles (Cycles B1, B2). The second and/or third placement cycles may be part of a selective assembly cycle and/or may use LED dies which have been tested e.g. individually tested.

There may be no LED wafer test before the first assembly cycle (cycle A). The first assembly cycle may only comprise picking and placing of the µLEDs. There may be a LED wafer test before the second and/or third assembly cycles (Cycles B1 and/or B2).

In exemplary methods, there may be an inline LED die test when placed on the panel between all placement cycles. The probability of each display pixel working is sufficiently high after three placement cycles of the defined number of µLED dies per pixel that it is now possible to obtain working products (displays) with a sufficiently low numbers of defects per display product that a manufacturing line repair strategy can be deployed, i.e. the display yield is sufficiently high that it is considered a 'manufacturable' process. This approach will give zero number of defects per display product for small displays, i.e. the cost increase due to multiple dies per pixel is immaterial for displays of small pixel numbers such as wearable technologies. This approach can be extended to large displays.

Subsequent µLED dies (after the first placement) may be single emitter µLED dies. This will reduce the size of the µLED dies that are used and reduce the cost.

Testing between each pick and place cycle may be used to identify defective, non-optimally performing µLED die or missing die as a result of die manufacture or assembly yields and substitute them with a working die at a redundant site located next to the defect µLED die. The working die is taken from a wafer bank of KGD which has been designated for repair work.

Optionally, a laser is used to cut the tracks for any emitter within a die that are placed but are defective and/or for excess emitters. Multiple but different numbers of LED emitters per pixel working in parallel may create image artefacts, which may not be acceptable.

A selectable PUT may also be used to repair a LED wafer or handle layer to get a 'virtual' wafer yield of 100% before submitting the wafer to the assembly processes described above. A selectable PUT may be used to 'repair' defects on a LED wafer or handle layer to produce LED wafers or handle layers having a ∼100% virtual yield.

In addition to an AOI approach to inspect LEDs, such as µLEDs, (functional, optical power, beam profile) an additional approach may be used, such as reverse biasing the LED and shining light onto it, i.e. getting it to act as a photodiode, and using the behaviour of the LED in photodiode mode to predict and characterise the LEDs parametric performance.

According to the invention in an aspect, there is provided a method for moving a semiconductor chip, the method comprising: contacting a pick up tool, PUT, head with a surface of a semiconductor chip at a first location, wherein the surface of the semiconductor chip comprises a deformable material configured to adhere to the PUT on contact; moving the PUT to a second location and releasing the semiconductor.

Optionally, the deformable material comprises an elastic material.

Optionally, the elastic material comprises an elastomeric material.

Optionally, the deformable material comprises a structured surface for contacting the PUT head and configured facilitate adhesion and/or release of the semiconductor chip.

Optionally, the structured surface comprises elongate pillars extending from the surface.

Optionally, the contact between the PUT head and the deformable material results in substantially no voids therebetween.

Optionally, the method further comprises depositing the deformable material on a surface of the semiconductor chip.

Optionally, the method further comprises removing the deformable material from the surface of the semiconductor chip. Optionally, removal of the deformable material is by a process of etching. Optionally, the removal of the deformable material is by one of dissolving the deformable material or washing the deformable material away using a solution.

Optionally, the deformable material is deposited on top of a sacrificial layer deposited on the surface of the semiconductor chip, and wherein the etching process etches away the sacrificial layer.

Optionally, the PUT head is substantially rigid and/or substantially planar.

Optionally, method further comprises selectively adhering the PUT head to one or more of a plurality of semiconductor chips.

Optionally, there are a plurality of semiconductor chips, the method further comprising selectively removing the deformable material from one or more semiconductor chips before contact with the PUT head such that the PUT head does not adhere to those semiconductor chips.

Optionally, the method further comprises adhering the PUT head to a plurality of semiconductor chip.

Optionally, the semiconductor chips comprise ILED and/or µLED chips.

Optionally, the second location is a substrate of a semiconductor device.

Optionally, the substrate comprises a glass or plastics thin film transistor panel.

Optionally, the method further comprises arranging a plurality of ILED and/or µLED chips on the substrate to form an image generator of a display.

According to the invention in another aspect, there is provided a method for forming an image generator of an LED display, the method comprising: depositing a deformable material on a surface of a plurality of ILED and/or µLED chips; contacting a pick up tool, PUT, head with the deformable material deposited on one or more of the plurality of ILED and/or µLED chips, such that the one or more of the plurality of ILED and/or µLED chips adheres to the PUT head; moving the PUT head such that the one or more ILED and/or µLED chips are positioned such that contacts of the one or more ILED and/or µLED chips are in electrical communication with pads of thin film transistors of a glass or plastics thin film transistor panel; and releasing the one or more ILED and/or µLED chips from the PUT head.

According to the invention in another aspect, there is provided an image generator for an LED display, comprising: a plurality of ILED and µLED chips arranged on a glass or plastics thin film transistor panel, wherein the one or more ILED and/or µLED chips have been arranged on the glass or plastics thin film transistor panel by: depositing a deformable material on a surface of the plurality of ILED and/or µLED chips; contacting a pick up tool, PUT, head with the deformable material deposited on one or more of the plurality of ILED and/or µLED chips, such that the one or more of the plurality of ILED and/or µLED chips adheres to the PUT head; moving the PUT head such that the one or more ILED and/or µLED chips are positioned such that contacts of the one or more ILED and/or µLED chips are in electrical communication with pads of thin film transistors of a glass or plastics thin film transistor panel; and releasing the one or more ILED and/or µLED chips from the PUT head.

According to the invention in another aspect, there is provided a method for moving a semiconductor chip, the method comprising: contacting a pick up tool, PUT, head with a surface of a semiconductor chip at a first location, wherein the surface of the semiconductor chip comprises an intermediate layer that is conformal and results in a conformal surface contact between the surface of the intermediate layer and the PUT head.

### Brief Description of the Drawings

Figure 1 is a schematic cross section of a µLED;
Figure 2 is a schematic view of an exemplary µLED die;
Figure 3 is a schematic view of an exemplary µLED die;
Figure 4 is a section through an exemplary display;
Figure 5 is a schematic view an exemplary display manufacturing method;
Figure 6 is a schematic view of an exemplary µLED die design;
Figure 7 is a schematic cross section of an exemplary µLED;
Figure 8(a) is a schematic cross section of an exemplary µLED;
Figure 8(b) is a schematic cross section of an exemplary µLED after substrate removal; Figure 9 is a schematic view of an exemplary substrate removal process;
Figure 10 is a schematic view of an exemplary substrate removal process;
Figure 11 is a schematic view of an exemplary non-selective deformable layer deposition process;
Figure 12 is a schematic view of an exemplary selective deformable layer deposition process;
Figure 13 is a schematic view of an exemplary selective deformable layer deposition process;
Figure 14(a) is a schematic view of an exemplary non-selective pick up process;
Figure 14(b) is a schematic view of an exemplary selective pick up process;
Figure 15(a) is a schematic view of an exemplary non-selective pick up process;
Figure 15(b) is a schematic view of an exemplary selective pick up process;
Figures 16(a) to 16(d) are schematic views of part of an exemplary display;
Figure 17 is a schematic view of exemplary µLED dies;
Figure 18 is a table of exemplary display yields;
Figure 19 is a flow diagram;
Figure 20 is a flow diagram;
Figure 21 is a flow diagram;
Figure 22 is section through an exemplary TFT layer;
Figure 23 is a schematic view of an exemplary bonding process;
Figure 24 is a schematic view of an exemplary bonding process;
Figure 25 shows a beam profile output from a commercial planar LED device and from µLED devices
Figure 26 shows an exemplary assembly process flow;
Figure 27 shows an exemplary assembly process flow; and
Figure 28 shows an exemplary assembly process flow.

### Detailed Description

The inventors have appreciated that ILED Displays may provide future generations of flat display image generators providing superior battery performance and enhanced brightness. The ILED Display is at a basic level a variation of the OLED display. The OLED concept is based on passing current through organic or polymer materials that are sandwiched between two glass planes to produce light.

ILED display manufacture refers to the assembly of semiconductor inorganic light emitting diode (ILED) or other microLED devices onto flexible substrates or substrates such as TFT glass substrates. The assembly of millions of small µLEDs chips to create an ILED display can create unique challenges, for example, when considering wafer and assembly yield losses and the test strategy during in-line assembly onto non-native substrates.

The inventors have further appreciated some challenges with ILED display manufacture, as set out below.

High LED wafer yields greater than or equal to 99.99% are ideally preferred for ILED display manufacture because the display industry takes a zero tolerance approach to pixel defects in a display. State of the art LED wafer manufacturing yields vary in the industry considerably depending on the product. A wafer yield >99.9% is considered unrealistic and is one of the primary obstacles to ILED Display manufacture given that the pixel count in displays range from 10s of thousands for wearable displays to 10s of millions for large area high resolution displays. Alternative strategies are needed which take into consideration existing wafer yield scenarios.

The dimensions of LED dies required for ILED Displays are significantly smaller in scale compared to standard LED dies for traditional luminaire/lighting applications. The means that traditional assembly methods are not compatible with these chips sizes and therefore finer placement solutions are needed. Specifically, smart assembly processes with resolutions to manipulate and handle small die improve ILED assembly on the glass panel. There is therefore a need for an assembly process with high throughput that can enable massive parallel pick and transfer of ILED dies of size < 10µm a side from the native LED wafer onto a glass TFT substrate at accuracies approximately below ±2µm or less.

Strategies for assembly include wafer repair where known bad die are replaced on the wafer with KGD die or the transfer of only KGD from the wafer to a temporary carrier for pick to the TFT substrate. Both approaches require complicated wafer probe card testing to determine KGD to generate a defect map on the wafer. These are considered uneconomical and redundant by the methods disclosed herein. Depending on the wafer yield, it may also not be practical or economical to either replace known bad die or transfer only KGD from a wafer to a temporary carrier for pick to the TFT substrate.

Smart assembly methods are being developed in the industry for ILED displays and range from "non-selective" elastomer conformal stamps, laser assisted transfer, direct self-assembly methods, fluidic assembly and selective MEMs based print heads. All techniques require the preparation of assembly ready chips where the bulk of the substrate is removed or the epilayer released from the substrate.

Non-selective pick and place assembly methods may only practical for small display sizes and where die and assembly yields after a first pick and place on the display are greater than 99.99%. As an example, a wearable 320 x320 pixel display format consists of 307,200 subpixels with 102,400 subpixels of each primary colour red, green. A yield of >99.99% results in 308 defective pixels which require replacement and repair. Replacement and repair strategies at these numbers can be time consuming and not economical for a wearable cost of goods. Alternative lower cost methods are needed.

Selective pick and place assembly may be a preferred solution in overcoming yields problems where the PUT only selects known good die (KGD) for assembly. This requires full wafer test capability where defective die are identified and a defective wafer map is established.

The inventors have appreciated that for ILED Displays to become a commercial reality, all of the above challenges may need to be solved. A manufacturing methodology is disclosed herein, which may address the specific needs of the ILED display industry and may overcome one or more shortfalls in existing technologies, such as low wafer yields, complicated wafer test methods and/or selective PUT tool design. Exemplary methods and apparatus disclosed herein may comprise a redundancy scheme. Exemplary methods and apparatus disclosed herein may use micro LEDs (µLEDs) for implementation in display, which may include displays ranging from wearable displays to larger laptop displays.

Generally, disclosed herein is a method for manufacture of displays. Exemplary displays may be used in display applications, such as a wearable display incorporating µLEDs.

As used herein, "µLED" technology encompasses micron size ILED devices that directionalise the light output and maximise the brightness level observed by the user. The µLED is disclosed in US7518149 and is a next generation ILED technology developed specifically to deliver directionalised light. As used herein, "directionalised light" encompasses collimated and quasi-collimated light. For example, directionalised light may be light that is emitted from a light generating region of an ILED and at least a portion of the emitted light is directed into a beam having a half angle. This may increase the brightness of the ILED in the direction of the beam of light.

A µLED may have a circular cross section, in which case a diameter of the µLED is typically less 20 µm. A µLED may have a parabolic structure etched directly onto the ILED die during the wafer processing steps. The parabolic structure may comprise a light emitting region of the µLED and reflects a portion of the generated light to form a quasi-collimated light beam emerging from the chip.

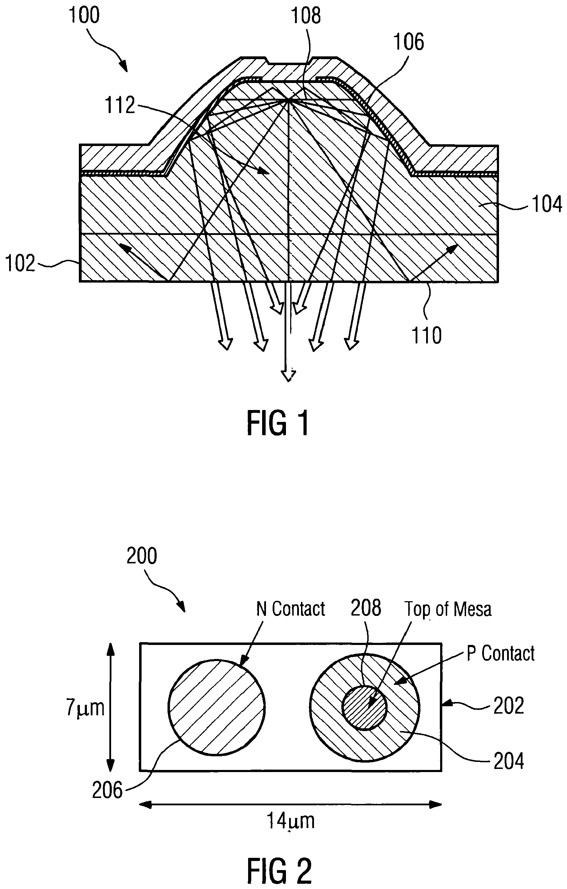

Figure 1 shows an exemplary µLED 100. The µLED 100 shown in Figure is the same or similar to that proposed in WO2004/097947 (also published as US 7,518, 149) having a high extraction efficiency and outputting quasi-collimated light because of the parabolic shape. A substrate 102 has a semiconductor epitaxial layer 104 located on it. The epitaxial layer 104 is shaped into a mesa 106. An active (or light emitting) layer 108 is enclosed in the mesa structure 106. The mesa 106 has a truncated top, on a side opposed to a light transmitting or emitting face 1 10 of the µLED 100. The mesa 106 also has a near-parabolic shape to form a reflective enclosure for light generated within the µLED 100. The arrows 1 12 show how light emitted from the active layer 108 is reflected off the internal walls of the mesa 106 toward the light exiting surface 1 10 at an angle sufficient for it to escape the µLED device 100 (i.e. within an angle of total internal reflection).

The parabolic shaped structure of the µLED 100 results in a significant increase in the extraction efficiency of the µLED 100 into low illumination angles when compared to unshaped or standard LEDs.

Figure 2 shows an exemplary µLED die 200. The die 200 comprises a single emitter 202 with a "p" electrode 204 and an "n" electrode 206 formed on the same side of the die 200 as a mesa 208. The light is output from a light emitting surface 210 on the opposite side of the µLED die 200 to the electrodes. The light is emitted through the epitaxial layer of the µLED die 200.

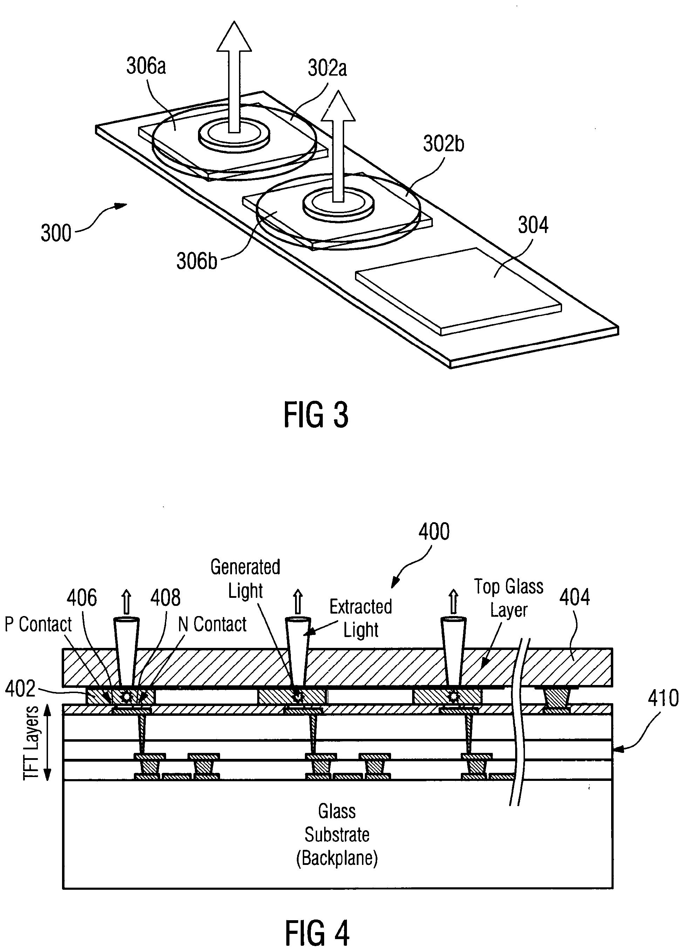

Figure 3 shows a perspective view of a µLED die 300 comprising a plurality of emitters 302a, 302b. The single die 300 of Figure 3 comprises two µLEDs. As used herein, the term "single die" encompasses a single and discrete section of substrate, e.g. a semiconductor substrate, on which semiconductor devices are fabricated. The die 300 comprises an n electrode 304 and a p electrode 306a, 306b for each µLED emitter 302a, 302b.

The size of the µLED die 300 is larger than the die 200 shown in Figure 3, as the number of µLED emitters is increased. However, in the case where multiple emitters are required and the n and p electrode formations are on the same side of the chip, the real estate used by the die 300 is reduced. For example, if two emitters are required, the die 300 represents a real estate saving in excess of 25% compared to two dies 200, which comprise a single emitter.

An advantage of apparatus disclosed herein is the interconnect configuration of the dies (i.e. p and n electrodes on an opposite side to the light emitting side). This configuration allows integrated testing of the dies 300 immediately after assembly onto a glass (or other transparent material) panel and before completion of a final display stack assembly. The manufacturing test strategy is therefore simplified and testing can be integrated into the assembly process. It will be appreciated that the interconnect configuration may also permit a simplified die repair or replacement strategy, which may be integrated into the assembly process.

Figure 4 is a cross section through a section of a display 400. The display 400 comprises a plurality of µLED dies 402 mounted on a glass top layer 404 such that emission of light is into and through the glass top layer 404. In the exemplary configuration of Figure 4, both the p and n electrodes 406, 408 are mounted on the same side of each die 402 and on an opposite face of the die 402 to the output face. Figure 4 shows how the µLED dies 402 may be mounted on TFT layers 410 of the display 400.

The p and n electrodes 406, 408 are on a lower surface of the dies 402 facing down and in direct contact with display active circuitry in the TFT layers 410 using suitable bonding layers. Further, the display comprises no patterned bank structures that, in other displays, are necessary to form conductive tracks and reflective layers to directionalise light upwards towards the top glass layer 404. The display 400 comprises a plurality of µLED dies 402 that inherently directionalise light output so reflective bank layers are not necessary. In other arrangements, the contacts of the µLED dies 402 may be formed on opposite sides of the die. This restricts final testing until topside passivation and full electrical interconnections are made. In exemplary methods and apparatus disclosed herein, the two contacts 406, 408 are facing down onto the TFT layers 410, which enables testing prior to any final passivation in the display final assembly.

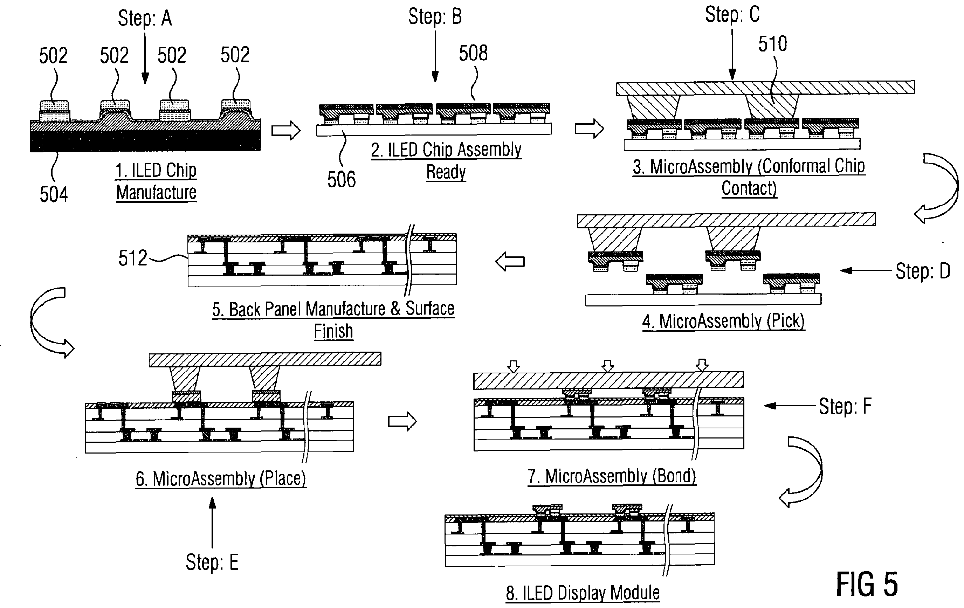

By way of example, Figure 5 illustrates a process flow for manufacturing the display 400 shown in Figure 4. The initial step (A) in the process is the manufacture of the µLED device 502. After the µLED fabrication, the devices 502 are removed from their epitaxial substrate 504. A mechanical layer is applied to the top surface of the devices 502, which acts as a handle layer 506 for subsequent processing steps. After transferring the devices 502 on to the handle layer 506, a conformal intermediate layer 508 is deposited on to a top surface of the devices 502 and the devices 502 are partially singulated, as shown in step B of Figure 5. The transfer head 510 of a PUT is a flat non-elastomeric head, which when applied to the intermediate layer results in conformal contact between the intermediate layer 508 and the transfer head 510 of the PUT (step D). This enables the devices 502 to be picked up and transferred to a display substrate 512 (or TFT layer) (step E).The transfer head 510 may be made from plastic, glass or silicon with a dimple protruding for each chip 502 to be picked up. Once the devices 502 are placed on the TFT layer 512, the transfer head 510 of the PUT can be removed from the intermediate layer 508. After placement of the devices 502 on the TFT layer, the intermediate layer 508 may be removed and the devices can be bonded to the TFT layer (step F). It should be understood that the methods disclosed herein are not restricted to the process flow described above and/or shown in Figure 5.

The steps of the exemplary process flow of Figure 5 will be described in more detail below.

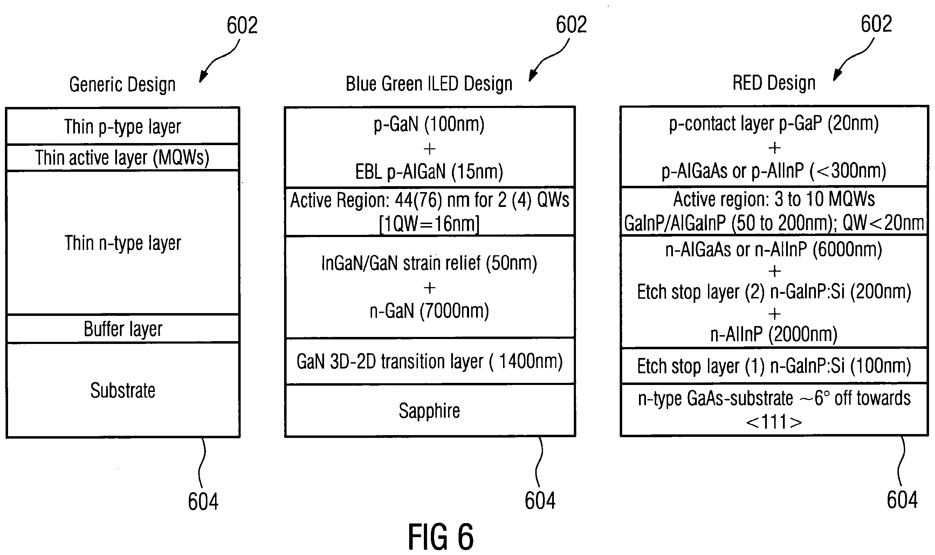

Figure 6 shows exemplary structures of the µLED devices 602. As can be seen in Figure 6, µLED devices for blue (e.g. λ = 470nm) and green (e.g. λ = 530nm) light emission are based on a GaN on sapphire 604 material system. Exemplary blue and green device 602 can include a multi quantum well structure (MQWs) as their active layer. In this example, the active layer is provided between p-type and n-type GaN layers. It will be appreciated that the device 602 may include one or more strain relieving layers.

Exemplary µLED devices for red (e.g. λ = 640nm) light emission can include Phosphide- or Arsenic-based epitaxial layers on a GaAs substrate 604. The active layer for the red device can also include a MQWs, which in this example is based on

Phosphide-containing heterostructures. It will be appreciated that in other examples, the MQWs may include one or more Arsenic-based heterostructures. The red devices can include one or more etch stop layers (ESL), which may be deposited in the GaAs substrate 604. It should be appreciated that the methods disclosed herein are not restricted to these materials or this device structure or those shown in Figure 6.

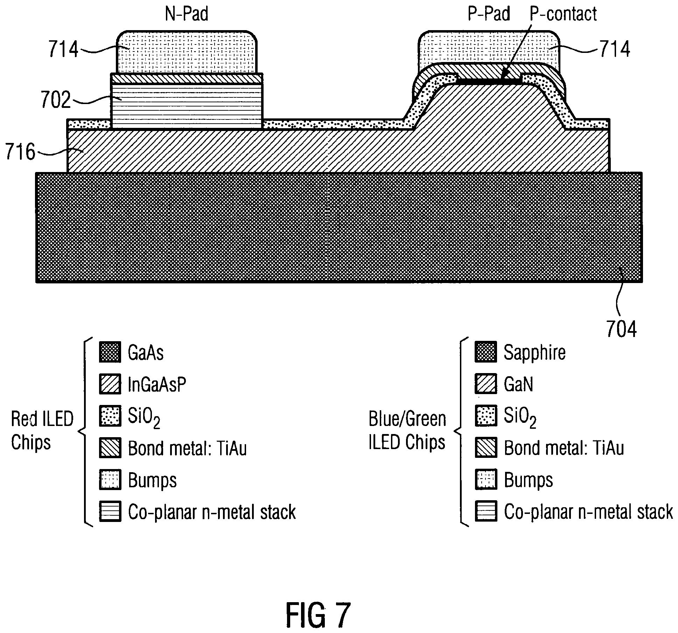

Figure 7 shows a cross section through an exemplary µLED device 702 (or ILED die) on the substrate 704, which can be a sapphire substrate for green and blue light emitting devices and GaAs substrate for red light emitting devices. The exemplary device 702 shown in Figure 7 is similar to those shown in Figures 1, 2 and 3. The device 702 of Figure 7 includes a bonding element, which is provided in the form of a bump or microbump 714, for interconnection of the devices 702 to the TFT layer. The bump 714 is arranged on the top surface of the devices 702 and above a contact pad. The contact pad includes the p- and n-contacts of the devices, which arranged on a single side of the devices opposite to the chip 702 emission side and has a diameter of about 5µm. The bump 714 can have a height of about 3 to 6µm and include a metal, e.g. CuSn or Cu, to permit interconnection to corresponding metal pads, e.g. Cu pads, on the TFT layer. Once the devices 702 have been transferred on to the TFT layer, the bumps 714 on the devices 702 are in temporary metal to metal contact, which allows testing of the devices 702. To test the devices 702, the devices 702 may not be permanently bond to the TFT layer. The temporary metal to metal contact between the bumps 714 and the metal pads on the TFT layer may permit testing of the devices 702 in a pre-bond state, i.e. temporary bond state. The bumps 714 on the devices 702 may allow for a high throughput multi-device to panel interconnection and bonding. Known C4 (controlled collapse chip connection) flip-chip technology cannot scale down to a target interconnect pitch due to bumps collapsing during bonding. The collapse of the bumps may cause bridging between the bumps which may be 10µm pitch or less.

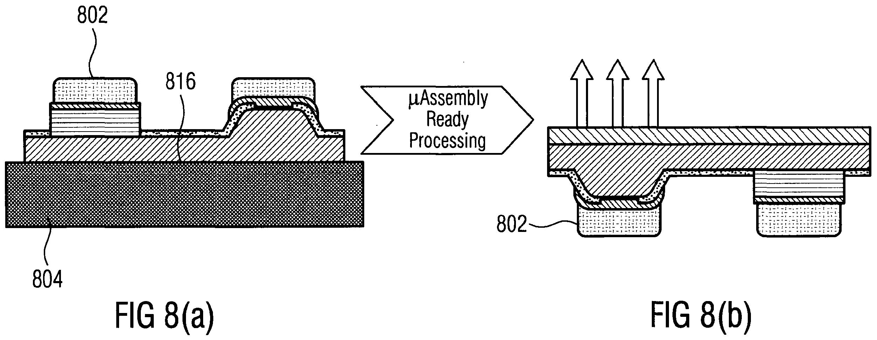

The exemplary µLED device 802 shown in Figure 8(a) is similar to that shown in Figure 7. The device 802 may have a length below 20µm, a width below 10µm and a thickness of about 3 to 8µm. The emitting surface 816 may have a roughness of less than 200nm. These properties/dimensions of the device 802 may be beneficial for assembly of the devices 802 on the TFT layer. However, it should be understood that the methods and apparatus disclosed herein are not restricted to µLED device having these properties/dimensions.

Figure 8(b) shows two exemplary µLED devices 802, which are similar to that shown in Figures 7 and 8(a). In Figure 8(b), the devices 802 have been removed from the substrate 804. Once the substrate 804 is detached from the devices 802, the devices 802 are inverted and can be further processed.

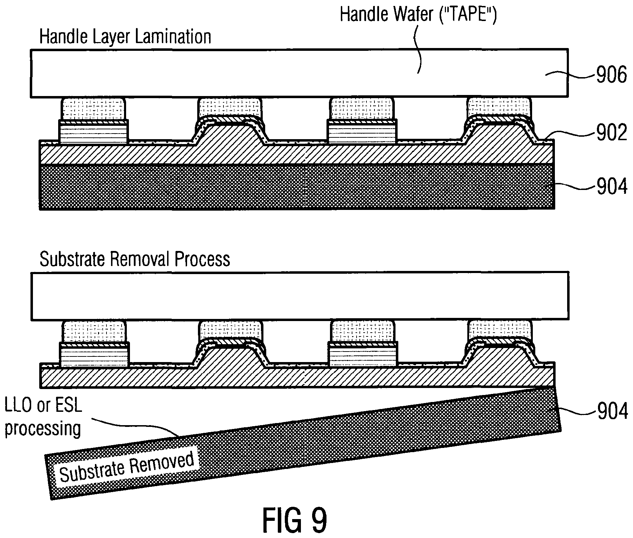

Removal of the substrate 904 from the devices 902 will be described in more detail below with reference to Figure 9.

Figure 9 shows an exemplary substrate removal process. Exemplary methods for substrate removal may include chemical etching and thinning of the substrate 904. Before the substrate 904 is removed, the handle layer 906 is applied to the top surface of the devices 902. One or more tape(s), such as one or more UV tape(s) (not shown), can be used to attached the devices 902 to the handle layer 906, The adhesion strength of the devices 902 to the handle layer 906 can be modified by irradiating the UV tapes with UV light. Other examples of tapes that can be used instead of the UV tape include thermal release tape, whose adhesion strength can be modified by exposing the tape to heat.

Once the handle layer 906 is applied a laser lift-off (LLO) process can be applied to the devices 902, which include a sapphire substrate. The laser lift-off process removes the sapphire substrate using a laser beam, such as a UV laser beam. The laser beam is directed through the sapphire substrate to the GaN layer of the devices 902 and creates a shockwave at the interface between the GaN layer and the sapphire substrate, thereby disassociating the GaN from the sapphire. The process can create free-standing GaN layers having a thickness of less than 10µm. The technology is of interest for high throughput and superior quality in the manufacture of high power LED chips or Nitride semiconductors grown on sapphire substrate, such as InGaN or GaN.

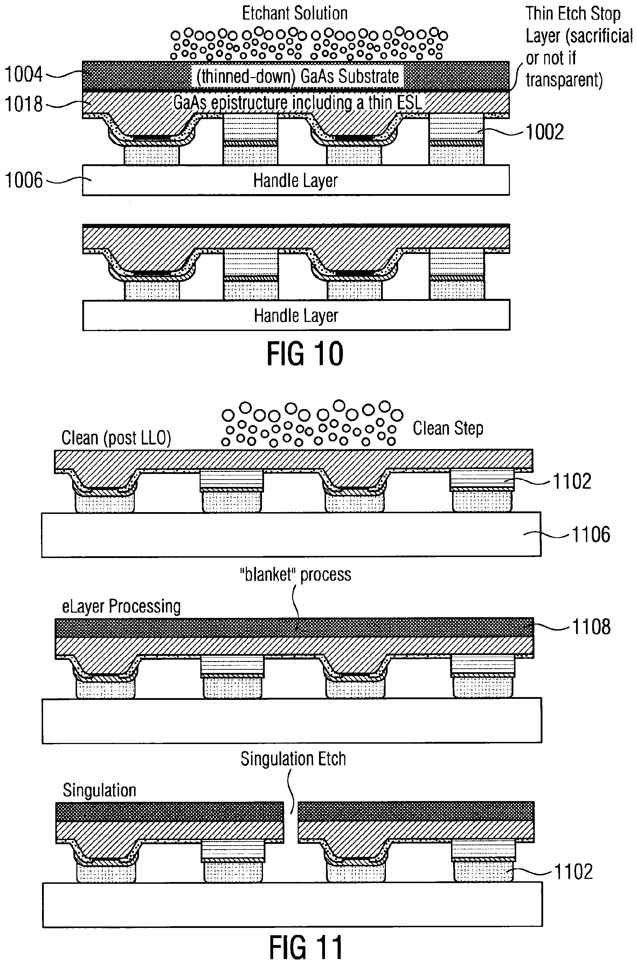

Figure 10 shows an exemplary process for the removal of a GaAs substrate from red µLED devices 1002. As described above, the red devices can include one or more etch stop layers (ESL), which are deposited on the GaAs substrate 1004 and separates the GaAs substrate 1004 from the epitaxial layers 1018 of the devices 1002. By way of example, the ESL can be formed by a single high Al-composition AIGaAs layer or an InGaP layer. In some examples two ESLs may be used to reduce the surface roughness. Depending of the application, the ESL may be kept or removed by selective dry and/or wet etching. In some exemplary processes, the GaAs substrate 1004 is thinned prior to selective wet/dry etching of the substrate 1004. This may accelerate the removal of the substrate 1004. In exemplary processes, the GaAs substrate 1004 is selectively removed by using organic acid-based (e.g. citric acid) or NH40H-based wet etchant, while the ESL can be selectively removed by HCI-based or HF-based wet etchant.

Referring to the top of Figure 11, in some examples, a cleaning step may be required after the removal of the substrate from the devices to remove any residue. This cleaning step may be applied after the sapphire or GaAs substrate removal process.

After the cleaning step, a deformable material can be deposited on the devices 1102 to form an intermediate layer 1108 (eLayer). This intermediate layer 1108 may be deposited on all devices 1102 on the handle layer 1106 (non-selective deposition) or to selected dies 1102 on the handle layer 1106 (selective deposition). The deposition of the intermediate layer 1108 will be explained in more detail below.

An exemplary deformable material used to form the intermediate layer 1108 includes an elastomer, which is transparent in the visible wavelength range, has a thermal stability,.e.g. up to 300°C, and a high chemical and physical stability. The deformable material may have a hardness of Durometer shore A 55 or a Young modulus of about 3MPa and may be curable by irradiating the deformable material with UV light or at low temperatures, such as temperatures below 125 °C.

Examples of the deformable material include a siloxane based elastomer, such as polydimethylsiloxane (PDMS). PDMS is non-toxic, biocompatible and can be used to form features having sizes in the nanometer range. The applications for PDMS are diverse and include as an example its use as a biomaterial to match the elastic modulus of soft tissues to study cell mechanobiology in muscle and nerves.

Figure 11 shows an exemplary process for non-selective deposition of the deformable material to form the intermediate layer 1108. Exemplary techniques for non-selective deposition can include one or more of spray coating, spin coating and lithography. Other exemplary techniques can include moulding preforms of the deformable material on the top surface of each die or microcontact printing on the surface of every device with the deformable material be used as an ink.

Subsequent to the formation of the intermediate layer 1108, the intermediate layer 1108 is removed in spaces between neighbouring devices 1102 and the devices 1102 are singulated, as shown in the bottom of Figure 11. An exemplary method for doing this includes patterning of the intermediate layer 1108 followed by a dry etch step using a metal hard mask. Dry etch used for patterning the intermediate layer 1108 can include SF6 and 02, while dry etch for singulation of the devices 1102 may include chlorine based etch. In other examples, the intermediated layer 1108 may be deposited on individual a device using, for example, a spray coating, moulding and stencil process. The use of the spray coating and stencil process may not require any patterning of the intermediate layer 1108.

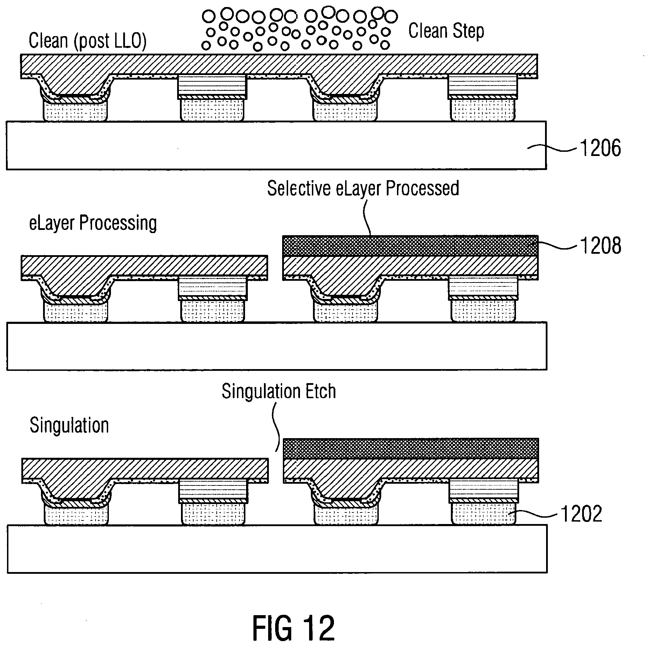

Figure 12 shows an exemplary process for selective deposition of the deformable material to form the intermediate layer 1208. The process is similar to that shown in Figure 11 and described above. However, in this example selective deposition of the deformable material is achieved by inkjet or super inkjet printing of the deformable material on selected devices 1202. These techniques include precision placement of small volumes, such as picolitre volumes, of deformable material, which in this example has a low viscosity, on the surface of the selected devices 1202. After the deformable material has been deposited on the selected devices 1202, the devices 1202 are singulated using the dry etch process described above.

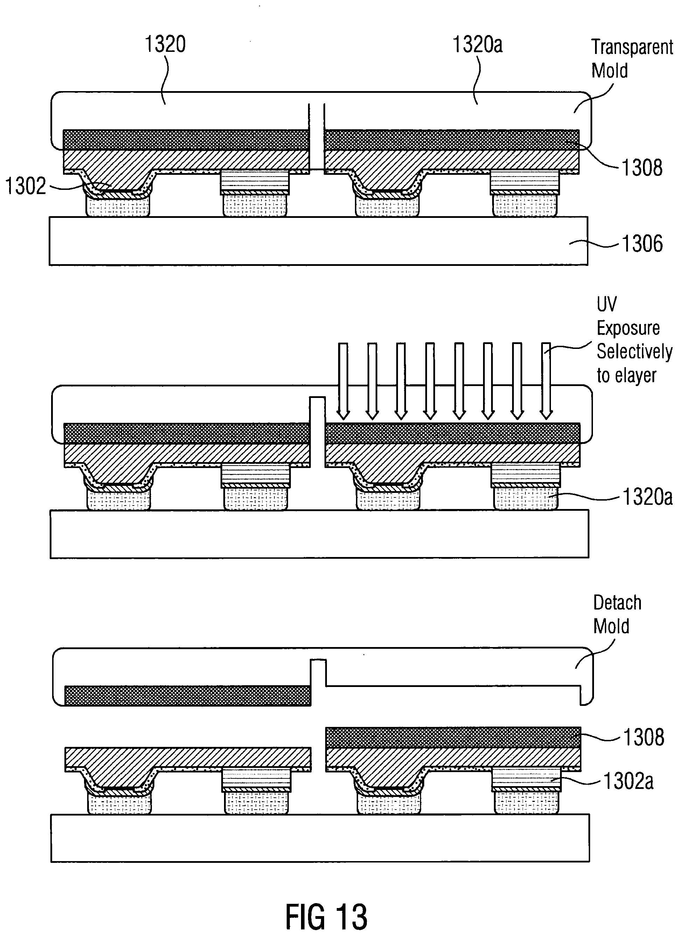

An alternative process for selectively depositing deformable material is shown in Figure 13. In this exemplary process the deformable material is applied to a mould 1320 and the mould 1320 is engaged with a surface of the devices 1302 so that the deformable material is in contact with the surface of the second LED dies. The mould is transparent to permit the deformable material to be irradiated with light. As used herein, the term light encompasses light of any wavelength including visible and invisible light. In the exemplary process shown in Figure 13, UV light is used. A portion 1320a of the mould 1320 is selectively irradiated with the UV light. The location of the portion 1320a of the mould 1320 corresponds to the location of a selected device 1302a. The irradiation of the portion 1320a of the mould 1320 with UV light cures the deformable material to the selected device 1302a. This increases a level of adhesion between the deformable material and the selected devices 1320a. When the mould 1320 is removed from the surface of the devices 1320, the deformable material adheres of the selected device 1302a, thereby forming an intermediate layer 1308 on the selected device 1302a. The deformable material that has not been cured is removed with the mould 1320 from the remaining device. It will be appreciated that this process may be used to deposit the deformable material to a plurality of selected devices, using either selective or non-selective methods, as disclosed herein.

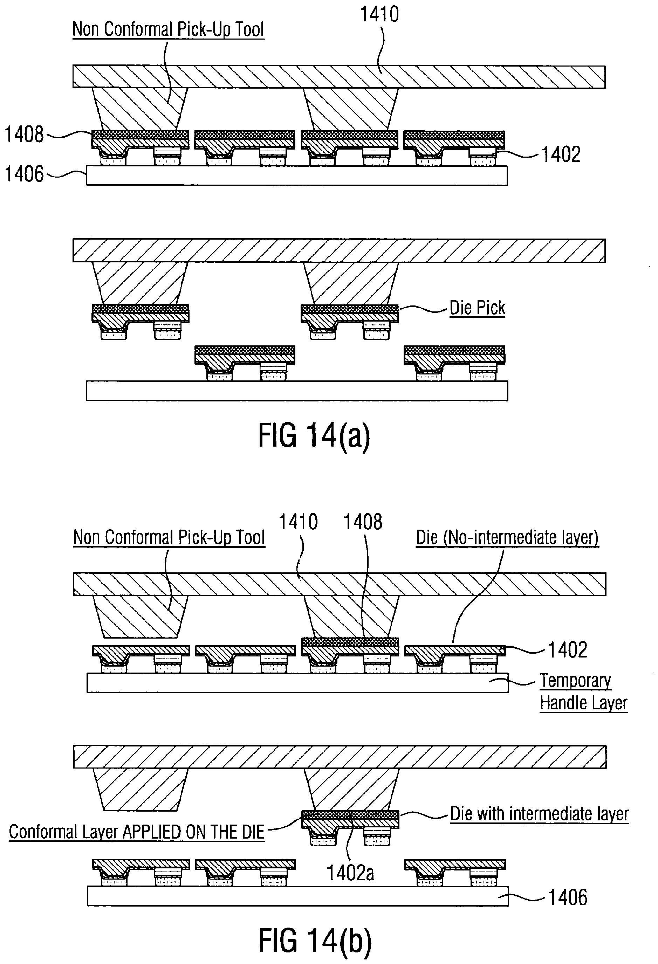

The pick-up of devices 1402 is shown in Figures 14(a) and 14(b). The transfer head 1410 of the PUT contacts the upper surface of intermediate layer 1408, which causes the devices 1402 to adhere to the transfer head 1410 through the intermediate layer 1408. The devices can then be transferred and placed on the TFT layer (not shown). Once placed, the transfer head 1410 can be removed from the conformal devices using a suitable release mechanism, such as adhesive surfaces on the transfer head 1510, which are switchable by the application of an external parameter (e.g. UV light, temperature and/or pressure). Alternatively or additionally, microstructures on the intermediate layer can be used to control adhesion force between the transfer head and the intermediate layer. The pick-up process shown in Figure 14(a) is referred to as non-selective pick up since every device 1402 has an intermediate layer 1408 applied to it. The PUT is a non-selective PUT and picks up every device 1402 that is contacted by the transfer head 1410 during the pick-up process, as shown in Figure 14(a).

In the example of Figure 14(b), the deformable material, which forms the intermediate layer 1408, has been applied to a selected device 1402a. The transfer head 1410 of the PUT only contacts the intermediate layer 1408 on the selected device 1402a. This results in only the selected device 1402a being picked up by the transfer head 1410 of the PUT, as shown in Figure 14(b). By applying the deformable material on selected devices, selective pick up of these devices, e.g. by a non-selective PUT may be permitted. This may negate the use of a selective PUT.

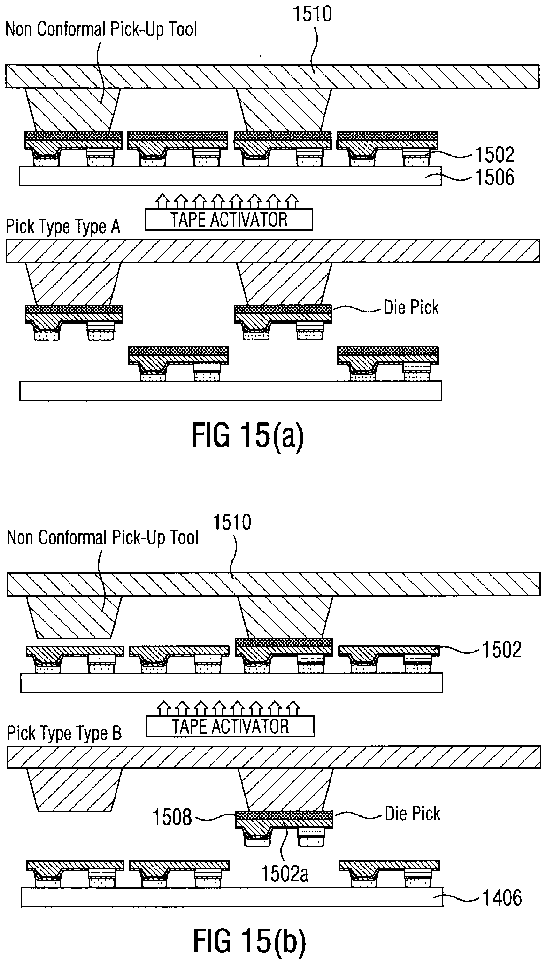

As described with reference to Figure 9, one or more UV tape(s) may be used to attach the devices to the handle layer. Figure 15(a) and 15(b) shows an exemplary non-selective and selective pick up process, respectively, in which the adhesion strength of the devices 1502 to the handle layer 1506 can be modified by irradiating the UV tapes with UV light. The irradiation of the tapes on the handle layer 1506 causes a level of adhesion between the devices 1502, 1502a and the handle layer 1506 to be less than a force applied by the transfer head 1510 of the PUT and thereby enables non-selective pick up and/or selective pick up of the devices 1502, 1502a from the handle layer 1506 by the transfer head 1510 of the PUT (e.g. as described above in relation to Figure 14(a) and 14(b)).

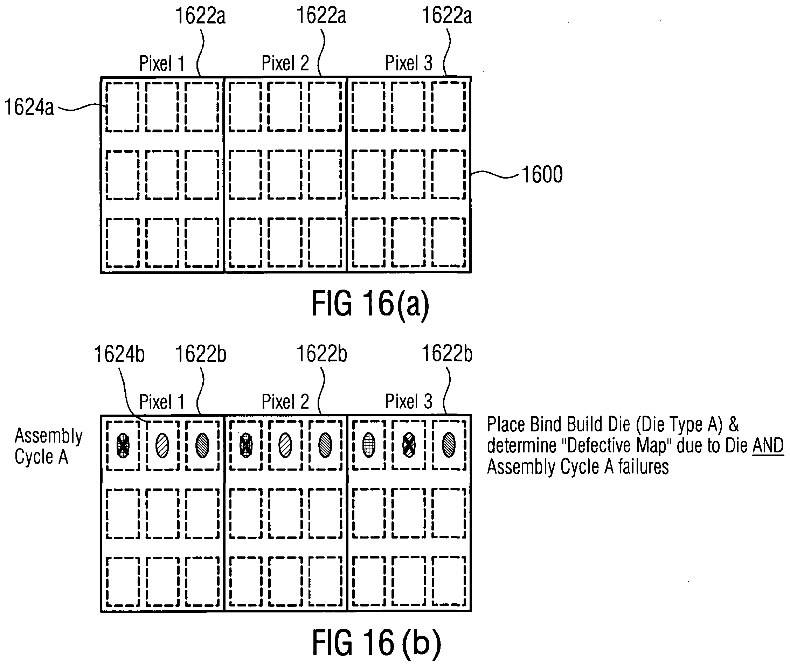

Figure 16(a) to 16(d) show a schematic view of an ILED or µLED display 1600 or part thereof. The display 1600 includes a 1x3 matrix of display pixel locations 1622a. Each pixel location 1622a includes a 3x3 matrix of sub-pixel locations 1624a, which results in each pixel having two redundant sub-pixel locations 1624a. Each sub-pixel may be populated with an ILED or µLED device. The device may include a single µLED emitter or a plurality of µLED emitters. The colour of the µLED emitters may be one of red, green or blue and may therefore be used to form a sub-pixel 1624b of a display pixel 1622b.

An exemplary display assembly process flow will be described in more detail below. The process may involve a single assembly station that undertakes a plurality of placement cycles. In other examples, a first placement cycle may be undertaken by a first assembly station and alternative assembly station may undertake the, or each, subsequent placement cycle(s).

In Figure 16(a) none of the sub-pixel locations 1624a are populated by a respective µLED device.

In a first placement cycle A, the PUT picks up an array of µLED devices from the handle layer, as described above. Each of the of the µLED devices in the array is configured to provide a sub-pixel 1624b of the display 1600. The array of µLED devices is placed on the TFT layer and may form a matrix of µLED devices of corresponding pixel locations on the display 1600. The placement may begin at one corner of what will become a display. The process of picking and placing is then repeated until all pixels 1622b of the display 1600 have a µLED die forming a sub-pixel 1624b of the pixel 1622b. When repeating the pick, the PUT may move the pick location on the handle layer sequentially to a next µLED device and move the place location to a next matrix of pixels of the display, which may be adjacent to the first matrix of pixels in a chess board pattern. Once all pixels of the display 1600 include a sub-pixel 1624b of one colour (red, green or blue), the picking and placing process is repeated for the remaining two colours. The result of this is a display including a plurality of pixels, each pixel including a µLED device of each of red, blue and green, as shown in Figure 16(b). The µLED device used in this first placement cycle A include untested µLED devices, e.g. µLED devices that have not been wafer tested and/or are inferred good dies (e.g. blind built).

Subsequent to the first placement cycle A, the µLED devices are tested to determine pixel locations of one or more non-functional or defective µLED emitter(s), which are crossed out in Figure 16(b). The test may comprise all devices having a current applied to them in reverse bias and/or forward bias. This may be done for all sub-pixels of each pixel. It is then determined whether any of the µLED devices are defective, i.e. do not contain a functional µLED emitter (e.g. using a photodetector, such as a camera) or has a parametric defect detected from the diode characteristics (e.g. using a filter), and at which pixel locations. The pixel locations of one or more non-functional or defective µLED emitter(s) are then recorded and stored in a defect map for cycle A, which may subsequently be used for the calibration of the display 1600.

Based on a result of the test, e.g. the defect map, one or more tested µLED devices or Know Good Dies (KGD), which may be positioned on another handle layer or on the same handle layer as the untested µLED devices but at a different location, are selected and configured to enable their pick up and placement by a PUT in the second placement cycle B1. The selected µLED devices are configured to provide the same sub-pixel of the display as the non-functional LED emitters. The step of configuring the tested µLED devices may include selective deposition of the deformable layer on the selected µLED devices, as described above.

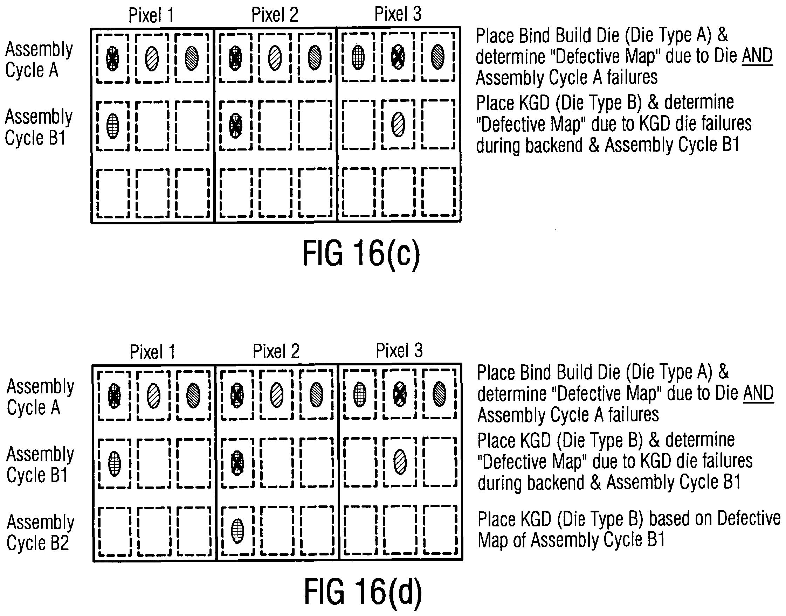

In the second placement cycle B1 the PUT picks up of one or more selected µLED devices and places the selected µLED devices on the TFT of the display 1600 at locations corresponding to the pixel locations of the non-functional LED emitters, as shown in Figure 16(c). By picking up and placing tested or KGD dies in the second placement cycle B1 on the TFT layer, the number of redundant µLED dies placed on the TFT layer and the number of placement cycles may be reduced, which may result in cost and time reductions.

The second process of picking and placing is then repeated until all pixels locations of non-functional µLED emitters have a selected µLED device, which forms a sub-pixel 1624b. When repeating the pick, the PUT may move the pick location on the handle layer mounting the selected µLED devices sequentially to a next selected µLED device and move the place location to a next pixel location having a non-functional µLED emitter. Once all pixel locations of non-functional µLED emitters include a sub-pixel 1624b of one colour (red, green or blue), the picking and placing process is repeated for the remaining two colours, as shown in Figure 16(c). The second placement cycle may be undertaken by a single assembly station.

Subsequent to the second placement cycle B1, the µLED devices are tested, as described above in relation to the first placement cycle A, to determine pixel locations of one or more non-functional or defective µLED emitter(s), which are crossed out in Figure 16(c). The pixel locations of one or more non-functional or defective µLED emitter(s) are then recorded and stored in a defect map for cycle B1, which may subsequently be used for the calibration of the display 1600.

Figure 16(c) shows that one of the three pixels includes no functional µLED emitters for the colour red. Based on a result of the test following the second placement cycle, e.g. the defect map for cycle B1, the selection of tested µLED dies or KGD is repeated. The second placement cycle B1 is then repeated as a placement cycle B2, as indicted in Figure 16(d).

The testing, selection and placement cycle B1 (or B2) may be repeated until there is a functional µLED emitter for each colour (red, green or blue) in nearly all (e.g. 99% or more) pixel locations of the display.

Exemplary µLED devices have their electrical contacts all on one side opposite the light emission surface, which enables the µLED devices to be powered for testing from the TFT layers immediately after placement.

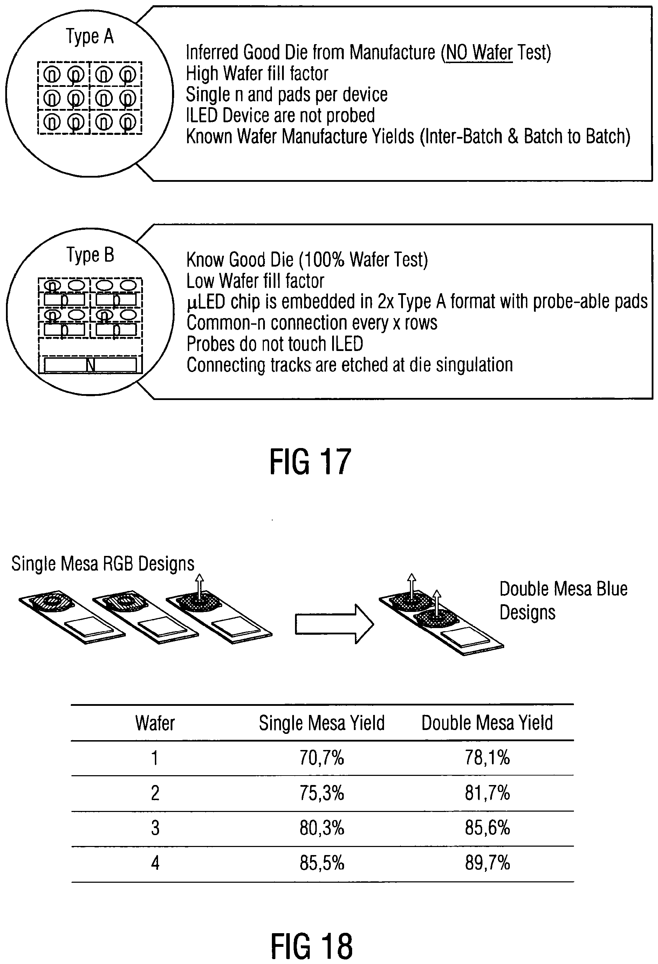

Exemplary µLED dies, which can be used in the first and second or any subsequent placement cycles, may have the same performance parameters. As described above, the µLED devices, which may be used in the first placement cycle, have not been tested at wafer level and are shown in Figure 17 as type A. The wafer yield of type A µLED devices may be known from wafer to wafer and batch to batch and controlled during manufacture. Figure 17 shows a 3x2 matrix of exemplary type A µLED devices and a 2x2 matrix of exemplary type B µLED devices. The type B µLED devices may be used in the second placement or any subsequent placement cycles. The type B µLED devices are KGD, e.g. have been tested at wafer level, e.g. using probes cards for example.

The type A dies may be manufactured in higher densities than the type B dies and have a single n- and p-contact on one side of the devices.

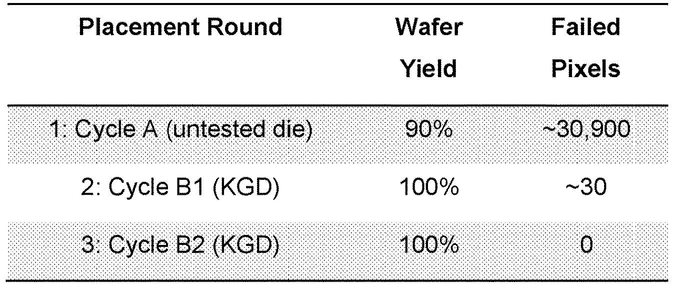

Table 1 illustrates an example of the number of failed pixels in dependency of the number of placement cycles. The display used to calculate the number of failed pixels in Table 1 is a 320x320 pixel colour display. The total number of sub-pixels requiring placement on the TFT layer for all colours (red, green or blue) is 307,200. In the example shown in Table 1, the wafer yield for untested µLED emitters is 90% and the assembly yield is 99.99%. This results in about 31,000 non-functional µLED emitters, which were identified after the first placement cycle.

As described above, during the second placement cycle, tested or KGDµLED emitters may be used. Although, the µLED emitters have been tested, there is the possibility that some of the µLED emitters are non-functional (e.g. the µLED emitters may have been damaged during the pick-up and place process or any of the previous process steps, described above). The example in Table 1 shows a yield loss of 0.001% or 10 non-functional µLED emitters. By repeating the second placement cycle, the number of non-functional µLED emitters may be decreased to zero, as show in Table 1. The increased wafer yield of the tested µLED may lead to a reduced number of placement cycles, which in turn may result in reduced time and cost needed to manufacture the display.

Figure 18 shows of comparison of display yields for µLED devices including a single emitter and µLED devices including a plurality of emitters (e.g. two emitters). When µLED devices comprises a plurality of emitters instead of a single emitter per LED die, Figure 18 shows that such plurality emitter devices can reduce the number of placement cycles and/or µLED devices required per pixel to obtain an acceptable display yield. The use of µLED devices including a plurality of emitters may reduce the time and/costs required for the assembly of a display.

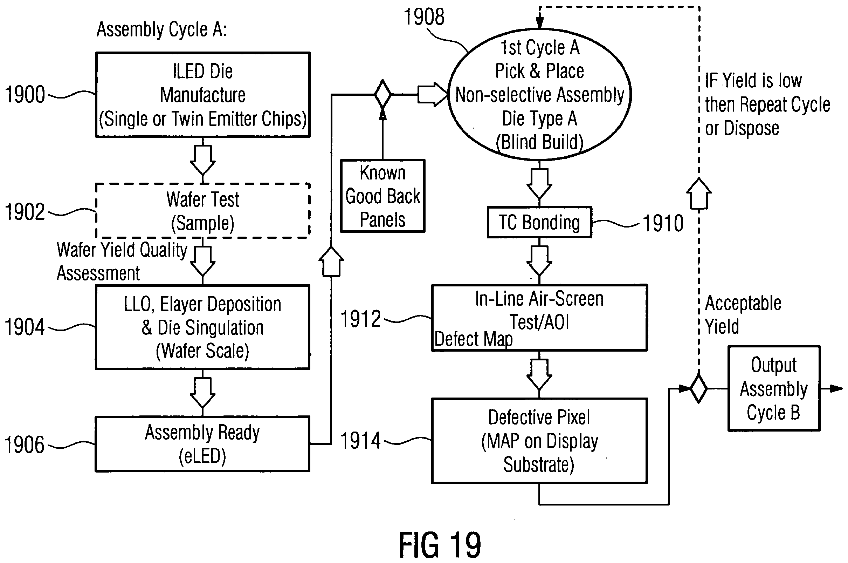

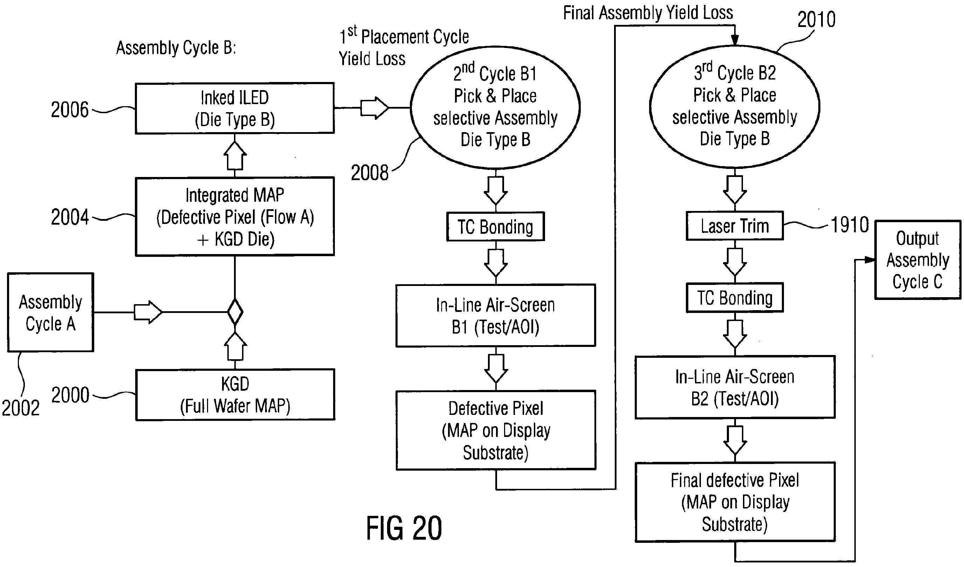

Figures 19 and 20 show the process flow of an exemplary manufacturing method.

Figure 19 shows the flow of an exemplary assembly cycle A, which is discussed above. The left hand side of the process flow of the assembly cycle A has been described above in relation to Figures 5 to 12. As shown on the left hand side in the process flow of cycle A, the manufactured µLED dies may be tested in some examples to assess a wafer yield quality. The right hand side of the process flow of assembly cycle A was described in detail in relation to Figures 16(a) to 16(d), The right hand side of the process flow of cycle A includes a bonding step, which will be described below.

First µLED dies are manufactured 1900 and may comprise one or more first µLED emitters. Optionally, a wafer test 1902 may be conducted on a sample of the first µLED dies to determine the wafer yield. The first µLED dies are configured 1904 for pick and place onto a display substrate, which may be a TFT substrate. The configuration may comprise placing the first µLED dies on a handle layer using, for example, LLO. The configuration may also comprise deposition of a deformable layer onto the first µLED die to allow adhesion to a PUT. The configuration may also comprise singulation of the first µLED dies. After configuration, the first µLED dies are assembly ready 1906 and may be placed on the display substrate in the first placement cycle 1908, which may comprise placing arrays of one sub-pixel type in a chessboard pattern until all pixels of a display include one of the first µLED die corresponding to the sub-pixel type and then repeating for the other two sub-pixel types. TCB 1910 may then take place. The first µLED dies are tested 1912, as discussed above, to determine 1914 one or more locations of non-functional first LED emitters, e.g. one or a plurality of the first emitters on a first µLED die may be non-functioning due to LED manufacturing process yields or damaged/missing due to assembly failures.

Figure 20 shows the flow of an exemplary assembly cycle B. The assembly cycle B includes the steps of bonding and trimming, which will be described below. The remaining steps shown in Figure 20 have been described above in relation to Figures 5 to 10, 12, 13 and Figures 16(a) to 16(d). A process of determining KGD 2000 may be undertaken to prepare a plurality of second µLED dies before integration of the test result 2002 from the first placement cycle (Figure 19). The results of the test may be used to determine a map 2004 of non-functional µLED die after the first placement cycle. Based on the results of the test, one or more second µLEDS are selected from the plurality of second µLEDs. For example, the sub-pixel type and/or location of the second µLED dies may correspond to the sub-pixel type and/or location of the non-functioning first µLED dies. The selected one or more second µLED dies are configured 2006 for pick-up by a PUT. This may be a selective pick-up process, such as those described above and may include the deposition of a deformable layer on the selected second µLED dies. The subsequent placement cycle 2008 is undertaken a similar way to the first placement cycle discussed above, although the further testing is optional and may be dependent on there being a further subsequent placement cycle 2010.

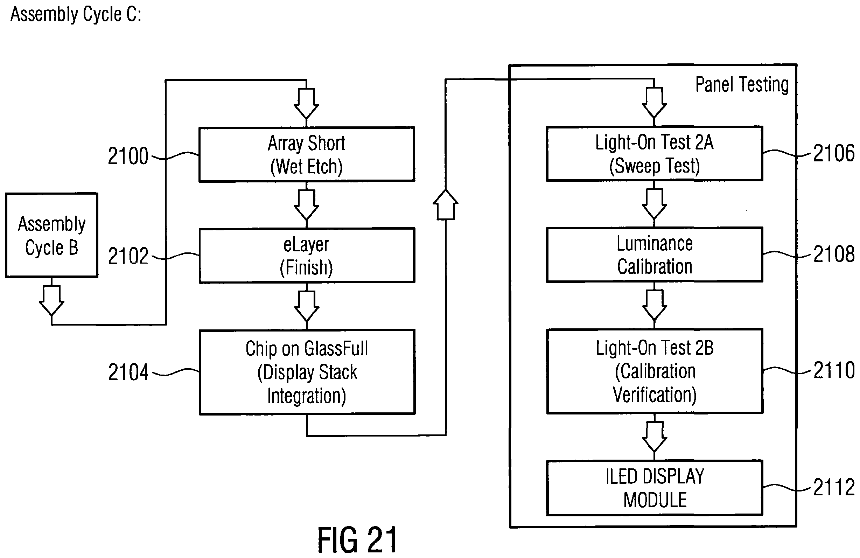

Figure 21 shows the flow of an exemplary assembly cycle C, which may be part of the exemplary manufacturing method described herein. Steps 2100-2104 of the assembly cycle C show the final steps of the display assembly.

Sidesteps 2106-2112 of the assembly cycle C show an exemplary calibration cycle of the assembled display. This calibration cycle may be based on the defect maps, which were generated following the first and second placement cycles A, B1 (or any subsequent placement cycles B2).

The calibration cycle can include the step of disconnecting one or more non-functional or defective µLED emitters of the µLED devices placed on the TFT layer. For example, non-functional or defective µLED emitters may be isolated from a drive circuit on the TFT layer using a laser trim process, which opens or melts connections of the defective µLED emitters to disconnect the µLED emitters from the drive circuit.

The calibration cycle may comprise a laser trim function to isolate or disconnect defective subpixels (e.g. defective µLED emitters) from the drive circuitry which were identified in first and/or second assembly cycles (Cycle A and/or Cycle B1) from the working µLED emitters placed during the third assembly cycle (Cycle B2). Electrical repair strategies may be used to isolate defective µLED defective µLED emitters identified after the first assembly cycle (Cycle A) from working µLED devices placed and tested during the second assembly (Cycle B1).

Although the step of disconnecting the defective µLED emitters is described as being part of the calibration cycle, it will be appreciated that in other examples the disconnecting step may be performed after each placement cycle (e.g. A, B1 or B2).

The second (or third) placement cycle may then be repeated until a predetermined display yield has been achieved.

The above described assembly cycles A and B include a step of bonding the µLED devices placed during the first, second or any subsequent placement cycles (e.g. A, B1 or B2) to the TFT layer. The bonding step may include temporary bonding (or pre- bonding) of the µLED devices to the TFT layer or permanently bonding of the µLED devices to the TFT layer.

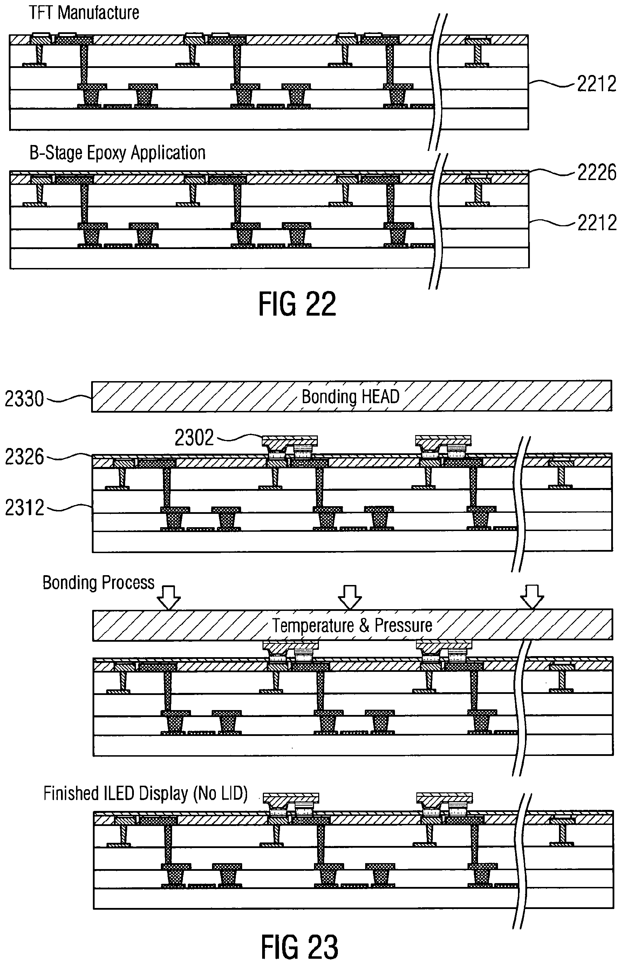

An exemplary process used for temporary bonding of the µLED devices to the TFT layer will be described with reference to Figure 22. As described above, a temporary bond between the µLED devices and contact pads on the TFT layer corresponds to a metal to metal contact between the bumps of the µLED devices and the contact pads on the TFT layer. This metal to metal contact may be a temporary bond, which permits testing of the µLED devices.

Figure 22 shows an example of a TFT layer 2212. In the bottom of Figure 22, an underfill or non-conductive layer 2226 has been deposited on the TFT layer 2212. The underfill or non-conductive film may be patterned onto the TFT layer 2212 between each placement cycle. Examples of underfills include B-stageable no flow underfills (BNUF), such as B-stage epoxy. B-stage epoxy is a descriptive term for an epoxy system that can be practically cured or "pre-dried" as an initial stage after being applied to a substrate or surface. At a later stage it can be completely cured under heat and pressure. The viscosity of the B-stage epoxy is complex as a function of temperature. The advantage of B-stage epoxy is that it can avoid manufacturing bottlenecks and increases production as final bonding does not have to immediately follow the application of the epoxy adhesive. Applications for B-stage epoxy includes hermetic packaging, flip-chip processing and optical gasket sealing of glasses. The underfill is deposited on the TFT layer at low temperature (typically < 100°C) and the µLED devices can then be placed on the TFT layer. At an elevated temperature, typically 100-200°C the viscosity of the B-stage epoxy is low to allow excess material to be squeezed out from the interface between the µLED devices and TFT layer and flow, thereby enabling the metal to metal contact to occur. During this temperature exposure, the B-stage epoxy may have concurrent flux capability to remove native oxide on the Cu. This allows testing of the µLED devices after each placement. At a higher temperature, typically 200-300°C, the µLED devices can be permanently bond to the TFT layer, e.g., by thermocompression bonding, which will be described below. After permanently bonding of the µLED devices to the TFT testing can be carried out. The use of the underfill, as described above may avoid a manufacturing bottleneck of thermocompression bonding since the permanent bonding step does not have to occur immediately after the deposition of the underfill and each placement cycle of the devices on the TFT layer. The use of the underfill may prevent oxidation of the metal contacts of the µLED devices and the TFT layer, which may include Copper.

The B-stage epoxy can assist in the adhesion between the µLED devices and the TFT layer, thereby facilitating the release of the µLED devices from the PUT after placement.

Figure 23 shows the final step of the exemplary manufacturing method disclosed herein. The µLED devices 2302 can be permanently bonded to the TFT layer 2312 using an exemplary thermocompression bonding (TCB) process. TCB may enable fine pitch 2.5D and 3D assembly technologies using fine pitch Cu pillar interconnects with pitches of about 40µm and pillar heights of 30µm. Placements accuracies are of the order of +2µm. TCB is, for example, used for memory products are driving the commercial volumes in the technology. Figure 23 shows an exemplary bonding head, which may be a thermocompression bonding head. The bonding head 2330 contacts the µLED devices 2302 on the TFT layer 2312 and creates a permanent bond between the µLED devices 2302 and the TFT layer 2312, e.g. by creating reflow of the bump of the µLED devices (e.g. eutectic) or metallic interdiffusion, e.g. Solid Liquid Interdiffusion (SLID). SLID involves an excitation source, such as a thermal, compression or ultrasonic forces to create a permanent bond.. In the example shown in Figure 23 the bonding head 2330 is of the same size as the TFT substrate 2312. This may lead to a high throughput and reduced costs. During the bonding the thermal expansion coefficients (TCE) of the µLED devices 2302 need to be matched to those of the TFT layer to reduce the thermomechanical stress in the assembled display and to achieve bonding across the TFT layer. The pre-applied underfill may act to distribute a thermal expansion mismatch between the device and the TFT layer and/or to reduce any stress in the bond between the µLED devices 2302 and the TFT layer 2312, thereby improving the quality of the metallurgical bond.

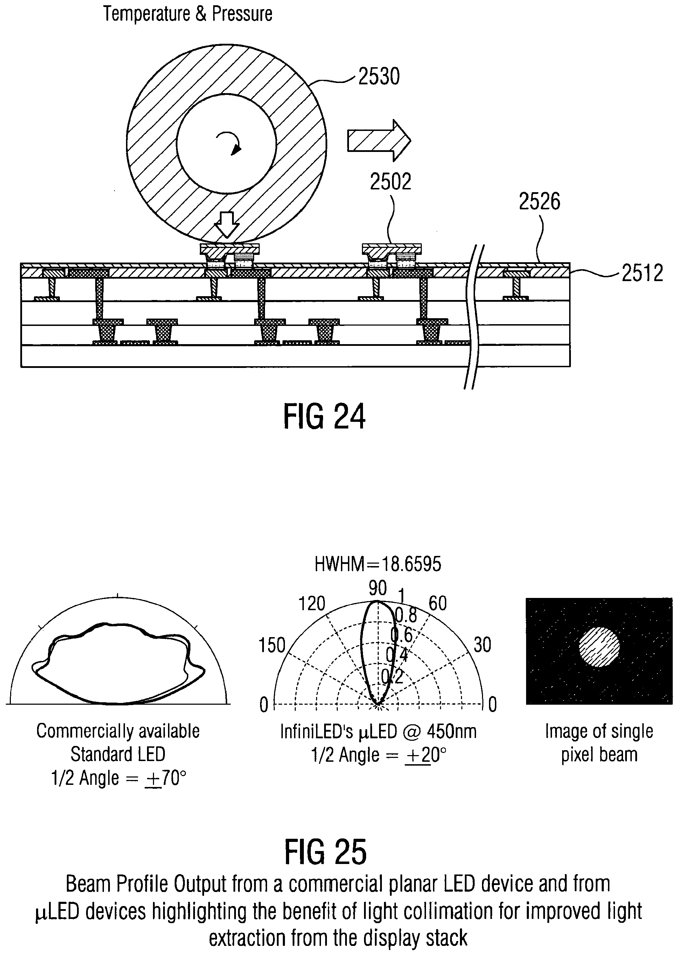

Figure 24 shows an alternative exemplary bonding head 2430, such as a TCB head, which may be used to bond the µLED devices 2402 to the TFT layer 2412. The TCB 2430 head is provided in the form of a drum, which is configured to move, e.g. rotate or roll, across the TFT layer 2412 and apply a force to the µLED devices. The drum applies a linear pressure along µLED dies 2402 on the TFT layer 2412. This may eliminate in-built stress and TCE mismatch between the TCB bond head and the TFT layer and/or may allow control of the necessary compression forces. In exemplary methods for display manufacture, one or more LED dies may be placed on a display substrate. The one or more LED dies may be placed on the display substrate according to any of the methods disclosed herein. The LED dies may comprise a bonding element, such as a bump or micro bump. A TCB head in the form of a drum may be used to provide a compressive force and a thermal transfer configured to activate the bonding element of the LED dies. The drum may be rolled across a plurality of LED dies in order to bond them to the display substrate.

Manufacturing processes are disclosed which address the assembly of semiconductor chips to form an ILED image generator for display products.

It is an objective of the methods and apparatus disclosed to provide an image generator and associated method of manufacture using a plurality of ILED chips which are specially designed to enable their contact and conformance to a PUT tool for handling and manipulation onto a TFT glass panel.

An Inorganic Light Emitting Diode (ILED) image generator is disclosed using a novel micro LED design and micro transfer assembly method. The ILED image generator comprises a substrate and a pluarility of µLED chips and an intermediate layer. In exemplary methods and apparatus, the term ILED encompasses a µLED. The intermediate layer is disposed onto at least one surface of the µLED chip and covers the µLED surface. The intermediate layer is deformable and may conform to the surface of the PUT. The intermediate layer may be a continuous layer or can be patterned with microstructures which facilitate the adhesion of the µLED chip for pickup, transfer and release using a non-conformal Pick Up Tool (PUT) transfer head. After assembly the intermediate layer can be removed using a release layer or through chemical degradation.

The method disclosed facilitates the assembly of µLED chips in pre-determined positions to manufacture an ILED image generator.

An assembly method to manufacture inorganic light emitting diode (ILED) image generator for displays is disclosed. ILED displays are a new generation of display technology for use particularily, but not only, in energy sensitive/battery powered display applications such as wearables devices, wearable device, smart phone, tablet, laptop.

In exemplary methods and apparatus, an assembly method to manufacture an image generator for an ILED display is disclosed. Specifically, a method for pick and place (or movement) of ILED chips is disclosed using an intermediate layer which is on the ILED chip (and may be structured) and "intermediate" between the ILED chip and the print head during assembly. The use of the intermediate layer results in a conformal contact between the contact surface of the pick up tools (PUT) and the conformal (or deformable) surface of the intermediate layer leading to intimate contact substantially without voids - a necessity for optimal stiction of the ILED chip onto the contact surface of the PUT. The chips whether individually or collectively form the subpixels of the display pixel and are assembled using this technique onto a glass thin flim transistor (TFT) panel in a predefined pitch to create the ILED image generator.

The term "µLED technology" as used herein encompasses micron size LED device manufacture which directionalise the light output and maximise the brightness level observed by the user. The µLED as disclosed in US7518149 is a next generation LED technology developed specifically to deliver directionalised light, i.e. only to where it is required. The µLED is typically < 20µm in diameter with a parabolic structure etched directly onto the LED die during the wafer processing steps to form a quasi-collimated light beam emerging from the chip (Figure 25). The micro ILED emitter shows a micro ILED structure similar to that proposed in WO 2004/097947 (US 7,518, 149) with a high extraction efficiency and outputting quasi-collimated light because of its shape. Such a micro ILED 300 is shown in Figure 1.

This shaped structure results in a significant increase in the efficiency into low illumination angles when compared to unshaped or standard LED chips, see Figure 25. This increased efficiency and collimated output of the µLED is such that it can produce light visible to the human eye with only nano-amps of drive current.

Conformal µLEDs comprise of µLED chip having an intermediate layer. The intermediate layer is disposed onto at least one surface of the µLED chip and covers the µLED surface (i.e. emission surface 1 10 of Figure 1). The intermediate layer is conformal enabling this layer to form a conformal contact with another contact surface, such as a substantially rigid surface of a PUT.

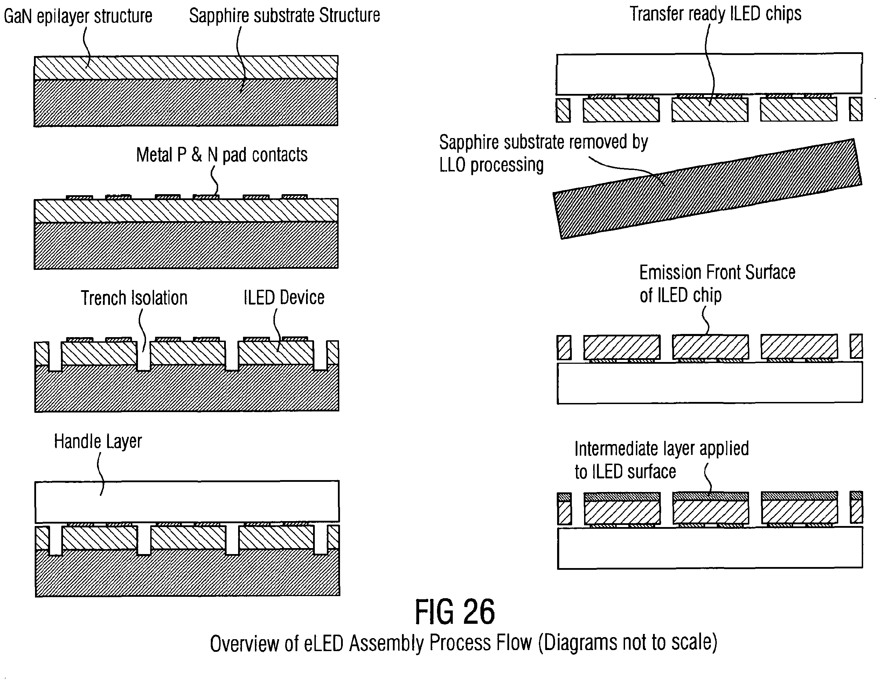

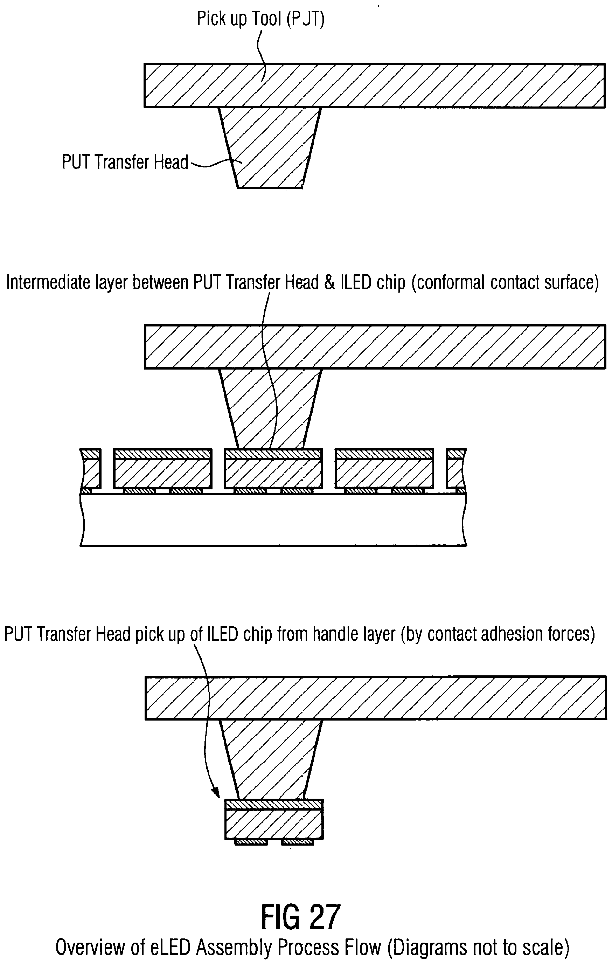

By way of example, process flows are disclosed in Figure 26, Figure 27 and Figure 28 based on GaN on sapphire material system for blue and green emitting µLEDs. It should be appreciated that this invention is not restricted to this material system nor the sequence of process flow proposed in this disclosure.

The process starts with a GaN on sapphire wafer with epi-layer and/or template plus the substrate which is tailored for ILED chip manufacture and assembly readiness.

The intial step in the process is the manufacture of the µLED device and together with a p and n contact pad. After µLED fabrication the chips are partially singulated on the wafer by a combination of photolithography to define a hard mask and dry etch methods (e.g. DRIE or ICP etch tools) which etches a typically 2µm wide, 3-5µm deep trench in the GaN epilayer/template between neighbouring devices. As an example, a SiOx hard mask is deposited and patterned using deep UV resist & photolith tools to transfer the defined pattern into the SiOx using CF4/CHF3 ICP etch chemistry. This is followed by a second chlorine based etch chemistry to etch the GaN. The hard mask is left on the devices for isolation purposes.

After the partial singulation, a mechanical layer is applied to the top surface which acts as a handle layer for subseqent processing steps. Once the handle layer is applied a laser lift-off process is applied which removes the sapphire substrate using a laser beam. Laser lift-off processing is a technique to detach the sapphire substrate from the GaN epilayers using excimer laser photons. The technology is of interest for high throughput and superior quality in the manufacture of HB-LEDs (high brightness) and flexible displays.

Once the sapphire substrate is detached the structure is inverted and presented for further thin-film processing. Specifically according to this invention an intermediate layer is applied to the emitting surface of the µLED chip; i.e. surface 110 in Figure 1. The chip after LLO processis now fully singulated with the substrate removed and mounted to the handle layer.

The intermediate layer may comprise of a two layer structure consisting first of a sacrifical layer such as a resist which is deposited on the emitting surface. A second conformal (or deformable) layer such as an elastomer is then applied on top of the sacrifical layer. The intermediate layer may be removed in the trenches between neighbouring devices in order to ensure the devices remained separate. A method for doing this includes a photolithography step to define and hard mask followed by a dry etch step.

The intermediate layer is referred to as being intermediate by location between the ILED chip and the transfer head used to pick up and place the die (semiconductor chips).

The intermediate layer is conformal and is a continuous layer across the surface of the µLED chip having a substantially uniform thickness. Alternatively, the intermediate layer can be patterned with microstructures which facilitate the pick up, transfer and/or release using a non-conformal transfer head. The intermediate layer is patterned such that the intermediate layer is patterned directly over the ILED chip so that the devices remain separated.

The transfer head or pick up tool (PUT) transfer head is a flat non-elastomeric head which when applied to the conformal intermediate layer on the µLED device resulting in a conformal contact which enables the chip to be picked up. The pick-up head maybe made from plastic, glass or silicon with a dimple protruding for each ILED chip to be picked up.

Die that are picked up are directly transferred to and bonded to the TFT pads of the glass panel. Once placed and/or bonded, the pick-up head can be removed from the conformal ILED chip using a suitable release mechanism. Mechanisms to release the PUT transfer head from the intermediate layer include 1). pull to generate sufficent peel strength to detach, 2). switchable adhesives surfaces on the PUT transfer head where the adhesive is switched by the application of an external parameter (examples include UV radiation, temperature & pressure) 3). Microstructures on the intermedicate layer which can control the adhesion forces between the transfer head and the intermediate layer.

After assembly the intermediate layer can be removed by etching or removal of the sacrifical layer which is a release layer which effectively lift-offs the elastomer layer from the ILED chip.

In other embodiments of this invention, it maybe acceptable or desirable to leave the elastomeric layer on the chip. In this case the intermediate layer need only be a single layer without the underlying sacrifical layer.

The integration of the elastomeric layer with the ILED chips provides a significant benefit for display manufacture. The ability to selectively pick ILED devices represents a significant challenge. Current approaches focus on the selective addressing at the PUT. In the disclosed exemplary methods and apparatus, the material that enables the pick (i.e. the adhesive layer) is on the individual chips. As such this layer can be selectively modified to stop the pick of non-function devices. This could be achieved using a number of techniques. In an exemplary embodiment, a Digital Micro- mirror Device (DMD) can be used to scan a laser beam across the surface of the ILED wafer. This laser beam is used to selectively damage the elastomeric layer of the ILEDs which are not functioning. This would prevent the devices from binding to the PUT and from being picked. The ability to provide a wafer in which no non-functioning devices can be picked results in a great simplification of the assembly process.

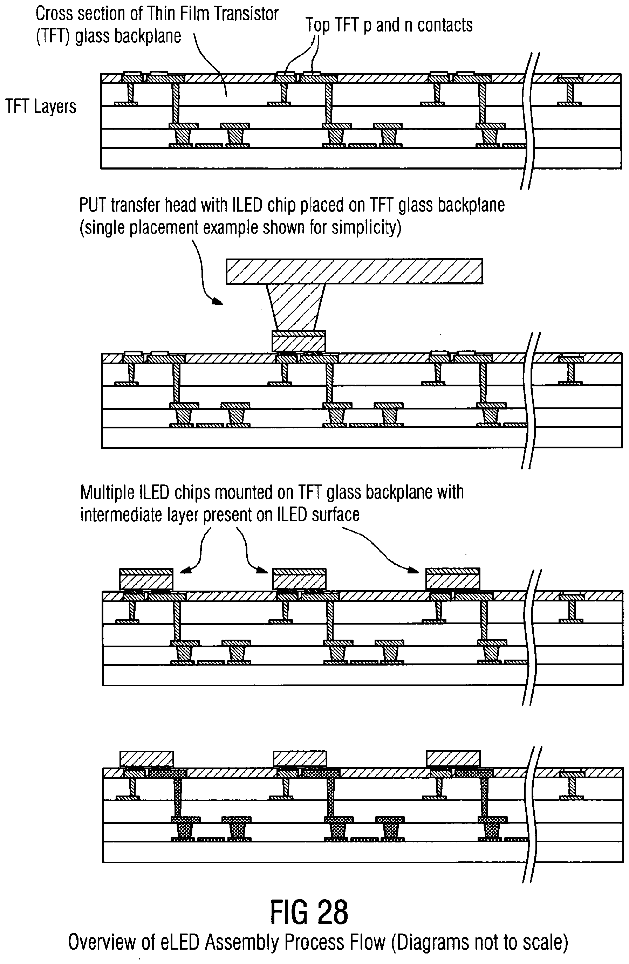

This method facilitates the assembly of µLED chips in predetermined positions to manufacture an ILED image generator, see Figure 28 which is an exemplary cross section through an ILED display. The die is referred to as a display subpixel and consists of single emitter per chip with p and n electrodes formed on the same side as the mesa. The light output is in the opposite direction and through the epilayer of the ILED device. Figure 28 is a simple concept illustration of an ILED Display. R, G and B ILED's are assembled onto a TFT glass panel substrate. Electrical tracks connects to the µLED with the electrode typically to the p-contact of the µLED and a separate electrode or ground to the n-contact - facilitating two contacts down approach as shown in this Figure. Further assembly of critical element of the full stack for an ILED image generator is not included in this disclosure but is assumed for an ILED display product. These include touch screen sensors, polarisers, glass cover etc.

A computer program may be configured to provide any of the above described methods. The computer program may be provided on a computer readable medium. The computer program may be a computer program product. The product may comprise a non-transitory computer usable storage medium. The computer program product may have computer-readable program code embodied in the medium configured to perform the method. The computer program product may be configured to cause at least one processor to perform some or all of the method.

Various methods and apparatus are described herein with reference to block diagrams or flowchart illustrations of computer-implemented methods, apparatus (systems and/or devices) and/or computer program products. It is understood that a block of the block diagrams and/or flowchart illustrations, and combinations of blocks in the block diagrams and/or flowchart illustrations, can be implemented by computer program instructions that are performed by one or more computer circuits. These computer program instructions may be provided to a processor circuit of a general purpose computer circuit, special purpose computer circuit, and/or other programmable data processing circuit to produce a machine, such that the instructions, which execute via the processor of the computer and/or other programmable data processing apparatus, transform and control transistors, values stored in memory locations, and other hardware components within such circuitry to implement the functions/acts specified in the block diagrams and/or flowchart block or blocks, and thereby create means (functionality) and/or structure for implementing the functions/acts specified in the block diagrams and/or flowchart block(s).

Computer program instructions may also be stored in a computer-readable medium that can direct a computer or other programmable data processing apparatus to function in a particular manner, such that the instructions stored in the computer-readable medium produce an article of manufacture including instructions which implement the functions/acts specified in the block diagrams and/or flowchart block or blocks.

A tangible, non-transitory computer-readable medium may include an electronic, magnetic, optical, electromagnetic, or semiconductor data storage system, apparatus, or device. More specific examples of the computer-readable medium would include the following: a portable computer diskette, a random access memory (RAM) circuit, a read-only memory (ROM) circuit, an erasable programmable read-only memory (EPROM or Flash memory) circuit, a portable compact disc read-only memory (CD- ROM), and a portable digital video disc read-only memory (DVD/Bluray).

The computer program instructions may also be loaded onto a computer and/or other programmable data processing apparatus to cause a series of operational steps to be performed on the computer and/or other programmable apparatus to produce a computer-implemented process such that the instructions which execute on the computer or other programmable apparatus provide steps for implementing the functions/acts specified in the block diagrams and/or flowchart block or blocks.

Accordingly, the invention may be embodied in hardware and/or in software (including firmware, resident software, micro-code, etc.) that runs on a processor, which may collectively be referred to as "circuitry," "a module" or variants thereof.

## Claims

1. A method for manufacturing a display (400, 1600) element comprising a plurality of pixels (1622b), each pixel (1622b) comprising a plurality of sub-pixels (1624b), each sub-pixel (1624b) being configured to provide light of a given wavelength, the method comprising:
undertaking, using a pick up tool (PUT), a first placement cycle (1908) comprising picking up a plurality of first, untested light-emitting diode (LED) dies (200, 300, 402), each first LED die comprising at least one first LED emitter configured to provide one of the plurality of sub-pixels (1624b) of the display (400, 1600), and placing the first LED dies (200, 300, 402) on a display substrate (512) at locations (1622a) corresponding to the plurality of pixels (1622b) of the display (400, 1600);
testing the first LED emitters on the display substrate (512) to determine one or more locations of non-functional first LED emitters;
testing a plurality of second LED dies each comprising at least one second LED emitter configured to provide one of the plurality of sub-pixels of the display to determine the plurality of second LED dies as known good dies;
from the plurality of second LED dies selecting one or more second LED dies based on a result of the test of the first LED emitters;
configuring the selected one or more second LED dies to enable their pick up and placement on the display substrate; and
undertaking, using the PUT, a second placement cycle (2008) comprising picking up the selected one or more second LED dies and placing the selected one or more second LED dies on the display substrate (512) at the determined locations of the nonfunctional first LED emitters.

2. The method according to claim 1, wherein configuring the selected one or more second LED dies comprises depositing a deformable material on the one or more selected second LED dies;
optionally, wherein the deformable material is configured to cause adhesion between the one or more selected second LED dies and the PUT during the second placement cycle (2008).

3. The method according to claim 2, wherein depositing the deformable material on the one or more selected second LED dies comprises applying the deformable material to a mould or carrier and engaging the mould or carrier with a surface of one or more of the selected second LED dies so that the deformable material is in contact with the surface of the one or more of the selected second LED dies;
optionally, wherein depositing the deformable material on the one or more selected second LED dies comprises modifying a level of adhesion between the deformable material and the one or more selected second LED dies so that the deformable material adheres to the one or more selected second LED dies;
wherein modifying the level of adhesion between the deformable material and the one or more selected second LED dies optionally comprises irradiating with light one or more portions of the mould or carrier element corresponding to locations of the one or more selected second LED dies;
wherein the light optionally comprises ultraviolet light.

4. The method according to claim 2 or 3, wherein prior to depositing the deformable layer on the one or more selected second LED dies, the method comprises placing the one or more selected second LED dies on a handle layer;
optionally, wherein the one or more selected second LED dies are adhered to the handle layer.

5. The method according to any preceding claim, wherein the second placement cycle (2008) comprises modifying a level of adhesion between the one or more second LED dies and the handle layer (906), such that the level of adhesion is less than a force applied by the PUT.

6. The method according to any preceding claim, wherein the method comprises depositing a deformable material on the plurality of first LED dies (200, 300, 402), prior to undertaking the first placement cycle (1908);
optionally, wherein the deformable material is configured to cause adhesion between the plurality of first LED dies and the PUT during the first placement cycle (1908).

7. The method according to any preceding claim, further comprising undertaking a further test of the first LED emitters and/or the second LED emitters after the second placement cycle (2008) to determine locations of one or more non-functional first and/or second LED emitters;
optionally, further comprising selecting one or more third, tested LED dies after undertaking the further test, based on a result of the further test.

8. The method according to claim 7, wherein the test and/or the further test comprises applying a reverse bias to the first and/or the second LED emitters and/or applying a forward bias to the first and/or second emitters and using one or more filter(s) to analyse the emission from the first and/or second LED emitters.

9. The method according to claim 7 or 8, further comprising undertaking one or more calibration cycles of an assembled display based on the results of the test and/or the further test;
optionally, wherein the one or more calibration cycles comprise disconnecting one or more non-functional first and/or second LED emitters from a drive circuitry on the display substrate (512).

10. The method according to any preceding claim, further comprising depositing an underfill or non-conductive film on the display substrate (512), prior to the first and/or second placement cycles (1908, 2008);
optionally, further comprising modifying a viscosity of the underfill or non-conductive film to enable pre-bonding or bonding of the first LED dies (200, 200, 402) and the selected one or more second LED dies to the display substrate (512).

11. The method according to any preceding claim, wherein the first and/or second LED dies comprise a bonding element arranged to permit interconnection of the first and/or second LED dies to the display substrate (512);
optionally, wherein the bonding element is configured to form a temporary contact with an electrical contact of the display substrate (512), thereby allowing testing of the first and/or second LED dies.

12. The method according to any preceding claim, further comprising bonding the first and/or selected one or more second LED dies to the display substrate (512) using a bonding head (2330);
optionally, wherein the bonding head (2330) comprises a drum configured to move across the display substrate (512) of the display (400, 1600) and apply a force to the first and/or selected one or more second LED dies positioned thereon.

13. The method according to any preceding claim, wherein the PUT is a non- selective PUT; and/or
wherein the first and second LED dies comprise micro-LED (µLED) dies comprising one or more respective µLED emitters;
optionally, wherein each µLED emitter comprises first and second electrodes configured to allow current to pass through the µLED emitter, and wherein the first and second electrodes are positioned on the same surface of the µLED die;
wherein the first and second electrodes are optionally positioned on a surface of the µLED die opposite an emission surface;
optionally, wherein the µLED dies comprise a plurality of µLED emitters, each configured to emit light of substantially the same wavelength;
wherein one of the first and second electrodes is optionally common to each of the plurality of µLED emitters.

14. A computer program comprising instructions, which when executed on at least one processor, cause the at least one processor to carry out the method according to any one of claims 1 to 13 or 16 to 18 or 19.

15. A carrier containing the computer program of claim 14, wherein the carrier is one of an electronic signal, optical signal, radio signal or non-transitory computer readable storage medium.

16. The method according claim 2 or 6, wherein the deformable material comprises an elastic material;
optionally, wherein the elastic material comprises an elastomeric material;

17. A method according to claim 16, wherein the contact between the PUT head and the deformable material results in substantially no voids therebetween; and/or
optionally, further comprising depositing the deformable material on a surface of the semiconductor chip; and/or
optionally, further comprising removing the deformable material from the surface of the semiconductor chip;
optionally, wherein removal of the deformable material is by a process of etching; and/or
wherein the deformable material is optionally deposited on top of a sacrificial layer deposited on the surface of the semiconductor chip, and wherein the etching process etches away the sacrificial layer.

18. A method according to claim 16 or 17, wherein the PUT head is substantially rigid and/or substantially planar; and/or
further comprising selectively adhering the PUT head to one or more of a plurality of semiconductor chips; and/or
wherein there are a plurality of semiconductor chips, the method further comprising selectively removing the deformable material from one or more semiconductor chips before contact with the PUT head such that the PUT head does not adhere to those semiconductor chips; and/or
further comprising adhering the PUT head to a plurality of semiconductor chips; and/or
optionally, wherein the semiconductor chips comprise Inorganic Light Emitting Diode (ILED) and/or micro-LED (µLED) chips;
optionally, wherein the second location is a substrate of a semiconductor device;
wherein the substrate optionally comprises a glass or plastics thin film transistor panel; and
optionally, further comprising arranging a plurality of ILED and/or µLED chips on the substrate to form an image generator of a display.

19. The method according to claim 1, wherein:
configuring the selected one or more second LED dies comprises depositing a deformable material on the one or more selected second LED dies; and
the deformable material comprises a structured surface for contacting the PUT head and configured facilitate adhesion and/or release of the semiconductor chip.

20. The method according to claim 19, wherein the structured surface comprises elongate pillars extending from the structured surface.

## Patentansprüche

1. Ein Verfahren zum Herstellen eines Anzeige(400, 1600)-Elements, das eine Vielzahl von Bildpunkten (1622b) beinhaltet, wobei jeder Bildpunkt (1622b) eine Vielzahl von Teilbildpunkten (1624b) beinhaltet, wobei jeder Teilbildpunkt (1624b) konfiguriert ist, um Licht einer vorgegebenen Wellenlänge bereitzustellen, wobei das Verfahren Folgendes beinhaltet:
Durchführen, unter Verwendung eines Greifwerkzeugs (PUT, Pick Up Tool), eines ersten Platzierungsarbeitsablaufs (1908), der das Greifen einer Vielzahl von ersten, ungeprüften Lichtemitterdioden(LED)-Dies (200, 300, 402), wobei jeder erste LED-Die mindestens einen ersten LED-Emitter beinhaltet, der konfiguriert ist, um einen der Vielzahl von Teilbildpunkten (1624b) der Anzeige (400, 1600) bereitzustellen, und Platzieren der ersten LED-Dies (200, 300, 402) auf einem Anzeigesubstrat (512) an Stellen (1622a), die der Vielzahl von Bildpunkten (1622b) der Anzeige (400, 1600) entsprechen, beinhaltet;
Prüfen der ersten LED-Emitter auf dem Anzeigesubstrat (512), um eine oder mehrere Stellen nicht funktionsfähiger erster LED-Emitter zu bestimmen;
Prüfen einer Vielzahl von zweiten LED-Dies, wobei jeder mindestens einen zweiten LED-Emitter beinhaltet, der konfiguriert ist, um einen der Vielzahl von Teilbildpunkten der Anzeige bereitzustellen, um die Vielzahl von zweiten LED-Dies als als funktionierend bekannte Dies (Known Good Dies) zu bestimmen;
aus der Vielzahl von zweiten LED-Dies, Auswählen eines oder mehrerer zweiter LED-Dies basierend auf einem Ergebnis der Prüfung der ersten LED-Emitter;
Konfigurieren des ausgewählten einen oder der ausgewählten mehreren zweiten LED-Dies, um ihr Greifen und ihre Platzierung auf dem Anzeigesubstrat zu ermöglichen; und Durchführen, unter Verwendung des PUT, eines zweiten Platzierungsarbeitsablaufs (2008), der das Greifen des ausgewählten einen oder der ausgewählten mehreren zweiten LED-Dies und das Platzieren des ausgewählten einen oder der ausgewählten mehreren zweiten LED-Dies auf dem Anzeigesubstrat (512) an den bestimmten Stellen der nicht funktionsfähigen ersten LED-Emitter beinhaltet.

2. Verfahren gemäß Anspruch 1, wobei das Konfigurieren des ausgewählten einen oder der ausgewählten mehreren zweiten LED-Dies das Ablagern eines verformbaren Materials auf dem einen oder den mehreren ausgewählten zweiten LED-Dies beinhaltet;
wobei das verformbare Material optional konfiguriert ist, um Haftung zwischen dem einen oder den mehreren ausgewählten zweiten LED-Dies und dem PUT während des zweiten Platzierungsarbeitsablaufs (2008) zu bewirken.

3. Verfahren gemäß Anspruch 2, wobei das Ablagern des verformbaren Materials auf dem einen oder den mehreren ausgewählten zweiten LED-Dies das Aufbringen des verformbaren Materials auf einer Form oder einem Träger und das In-Eingriff-Bringen der Form oder des Trägers mit einer Oberfläche eines oder mehrerer der ausgewählten zweiten LED-Dies beinhaltet, sodass das verformbare Material in Kontakt mit der Oberfläche des einen oder der mehreren der ausgewählten zweiten LED-Dies steht; wobei das Ablagern des verformbaren Materials auf dem einen oder den mehreren ausgewählten zweiten LED-Dies optional das Modifizieren eines Haftungsniveaus zwischen dem verformbaren Material und dem einen oder den mehreren ausgewählten zweiten LED-Dies beinhaltet, sodass das verformbare Material an dem einen oder den mehreren ausgewählten zweiten LED-Dies anhaftet;
wobei das Modifizieren des Haftungsniveaus zwischen dem verformbaren Material und dem einen oder den mehreren ausgewählten zweiten LED-Dies optional das Bestrahlen eines oder mehrerer Abschnitte des Form- oder Trägerelements, die Stellen des einen oder der mehreren ausgewählten zweiten LED-Dies entsprechen, mit Licht beinhaltet; wobei das Licht optional Ultraviolettlicht beinhaltet.

4. Verfahren gemäß Anspruch 2 oder 3, wobei das Verfahren vor dem Ablagern der verformbaren Schicht auf dem einen oder den mehreren ausgewählten zweiten LED-Dies das Platzieren des einen oder der mehreren ausgewählten zweiten LED-Dies auf einer Handhabungsschicht beinhaltet;
wobei der eine oder die mehreren ausgewählten zweiten LED-Dies optional an der Handhabungsschicht angehaftet werden.

5. Verfahren gemäß einem der vorhergehenden Ansprüche, wobei der zweite Platzierungsarbeitsablauf (2008) das Modifizieren eines Haftungsniveaus zwischen dem einen oder den mehreren zweiten LED-Dies und der Handhabungsschicht (906) beinhaltet, sodass das Haftungsniveau niedriger als eine durch das PUT ausgeübte Kraft ist.

6. Verfahren gemäß einem der vorhergehenden Ansprüche, wobei das Verfahren das Ablagern eines verformbaren Materials auf der Vielzahl von ersten LED-Dies (200, 300, 402) vordem Durchführen des ersten Platzierungsarbeitsablaufs (1908) beinhaltet; wobei das verformbare Material optional konfiguriert ist, um Haftung zwischen der Vielzahl von ersten LED-Dies und dem PUT während des ersten Platzierungsarbeitsablaufs (1908) zu bewirken.

7. Verfahren gemäß einem der vorhergehenden Ansprüche, das weiter das Durchführen einer weiteren Prüfung der ersten LED-Emitter und/oder der zweiten LED-Emitter nach dem zweiten Platzierungsarbeitsablauf (2008) beinhaltet, um Stellen eines oder mehrerer nicht funktionsfähiger erster und/oder zweiter LED-Emitter zu bestimmen; optional weiter beinhaltend das Auswählen eines oder mehrerer dritter, geprüfter LED-Dies nach dem Durchführen der weiteren Prüfung basierend auf einem Ergebnis der weiteren Prüfung.

8. Verfahren gemäß Anspruch 7, wobei die Prüfung und/oder die weitere Prüfung das Anlegen einer Sperrvorspannung an die ersten und/oder die zweiten LED-Emitter und/oder das Anlegen einer Durchlassvorspannung an die ersten und/oder die zweiten Emitter und das Verwenden eines oder mehrerer Filter zum Analysieren der Emission von den ersten und/oder den zweiten LED-Emittern beinhaltet.

9. Verfahren gemäß Anspruch 7 oder 8, das weiter das Durchführen eines oder mehrerer Kalibrierungsarbeitsabläufe einer montierten Anzeige basierend auf den Ergebnissen der Prüfung und/oder der weiteren Prüfung beinhaltet;
wobei der eine oder die mehreren Kalibrierungsarbeitsabläufe optional das Abtrennen eines oder mehrerer nicht funktionsfähiger erster und/oder zweiter LED-Emitter von einem Steuerkreis auf dem Anzeigesubstrat (512) beinhalten.

10. Verfahren gemäß einem der vorhergehenden Ansprüche, das weiter das Ablagern einer Unterfüllung oder eines nicht leitfähigen Films auf dem Anzeigesubstrat (512) vor dem ersten und/oder zweiten Platzierungsarbeitsablauf (1908, 2008) beinhaltet; optional weiter beinhaltend das Modifizieren einer Viskosität der Unterfüllung oder des nicht leitfähigen Films, um ein Vorbinden oder Binden der ersten LED-Dies (200, 200, 402) und des ausgewählten einen oder der ausgewählten mehreren zweiten LED-Dies an das Anzeigesubstrat (512) zu ermöglichen.

11. Verfahren gemäß einem der vorhergehenden Ansprüche, wobei die ersten und/oder die zweiten LED-Dies ein Bindungselement beinhalten, das angeordnet ist, um das Miteinanderverbinden der ersten und/oder der zweiten LED-Dies mit dem Anzeigesubstrat (512) zu erlauben;
wobei das Bindungselement optional konfiguriert ist, um einen temporären Kontakt mit einem elektrischen Kontakt des Anzeigesubstrats (512) zu bilden, wodurch das Prüfen der ersten und/oder der zweiten LED-Dies gestattet wird.

12. Verfahren gemäß einem der vorhergehenden Ansprüche, das weiter das Binden der ersten und/oder des ausgewählten einen oder der ausgewählten mehreren zweiten LED-Dies an das Anzeigesubstrat (512) unter Verwendung eines Bindekopfs (2330) beinhaltet;
wobei der Bindekopf (2330) optional eine Trommel beinhaltet, die konfiguriert ist, um sich über das Anzeigesubstrat (512) der Anzeige (400, 1600) zu bewegen und eine Kraft auf die ersten und/oder den ausgewählten einen oder die ausgewählten mehreren zweiten LED-Dies auszuüben, die darauf positioniert sind.

13. Verfahren gemäß einem der vorhergehenden Ansprüche, wobei das PUT ein nicht selektives PUT ist; und/oder
wobei die ersten und die zweiten LED-Dies Mikro-LED(µLED)-Dies beinhalten, die einen oder mehrere jeweilige µLED-Emitter beinhalten;
wobei jeder µLED-Emitter optional eine erste und eine zweite Elektrode beinhaltet, die konfiguriert sind, um zu gestatten, dass Strom durch den µLED-Emitter fließt, und wobei die erste und die zweite Elektrode auf derselben Oberfläche des µLED-Dies positioniert sind;
wobei die erste und die zweite Elektrode optional auf einer einer Emissionsoberfläche gegenüberliegenden Oberfläche des µLED-Dies positioniert sind;
wobei die µLED-Dies optional eine Vielzahl von µLED-Emittern beinhalten, wobei jeder konfiguriert ist, um Licht der im Wesentlichen selben Wellenlänge zu emittieren; wobei eine der ersten und der zweiten Elektrode optional jedem der Vielzahl von µLED-Emittern gemeinsam ist.

14. Ein Computerprogramm, das Anweisungen beinhaltet, die beim Ausführen auf mindestens einem Prozessor bewirken, dass der mindestens eine Prozessor das Verfahren gemäß einem der Ansprüche 1 bis 13 oder 16 bis 18 oder 19 vornimmt.

15. Ein Träger, der das Computerprogramm gemäß Anspruch 14 enthält, wobei der Träger eines von einem elektronischen Signal, optischen Signal, Funksignal oder nichttransitorischen computerlesbaren Speichermedium ist.

16. Verfahren gemäß Anspruch 2 oder 6, wobei das verformbare Material ein elastisches Material beinhaltet;
wobei das elastische Material ein Elastomermaterial beinhaltet.

17. Verfahren gemäß Anspruch 16, wobei der Kontakt zwischen dem PUT-Kopf und dem verformbaren Material im Wesentlichen in keinen dazwischenliegenden Lücken resultiert; und/oder
optional weiter beinhaltend das Ablagern des verformbaren Materials auf einer Oberfläche des Halbleiterchips; und/oder
optional weiter beinhaltend das Entfernen des verformbaren Materials von der Oberfläche des Halbleiterchips;
wobei die Entfernung des verformbaren Materials optional durch einen Ätzvorgang stattfindet; und/oder
wobei das verformbare Material optional über einer Opferschicht abgelagert wird, die auf der Oberfläche des Halbleiterchips abgelagert ist, und wobei der Ätzvorgang die Opferschicht wegätzt.

18. Verfahren gemäß Anspruch 16 oder 17, wobei der PUT-Kopf im Wesentlichen starr und/oder im Wesentlichen eben ist; und/oder
weiter beinhaltend das selektive Anhaften des PUT-Kopfs an einem oder mehreren einer Vielzahl von Halbleiterchips; und/oder
wobei es eine Vielzahl von Halbleiterchips gibt, wobei das Verfahren weiter das selektive Entfernen des verformbaren Materials von einem oder mehreren Halbleiterchips vor dem Kontakt mit dem PUT-Kopf beinhaltet, sodass der PUT-Kopf nicht an diesen Halbleiterchips anhaftet; und/oder
weiter beinhaltend das Anhaften des PUT-Kopfs an einer Vielzahl von Halbleiterchips; und/oder
wobei die Halbleiterchips optional anorganische Lichtemitterdioden(ILED)- und/oder Mikro-LED(µLED)-Chips beinhalten;
wobei die zweite Stelle optional ein Substrat einer Halbleitervorrichtung ist;
wobei das Substrat optional eine Dünnfilmtransistorplatte aus Glas oder Kunststoff beinhaltet; und
optional weiter beinhaltend das Anordnen einer Vielzahl von ILED- und/oder µLED-Chips auf dem Substrat, um einen Bilderzeuger einer Anzeige zu bilden.

19. Verfahren gemäß Anspruch 1, wobei:
das Konfigurieren des ausgewählten einen oder der ausgewählten mehreren zweiten LED-Dies das Ablagern eines verformbaren Materials auf dem einen oder den mehreren ausgewählten zweiten LED-Dies beinhaltet; und
das verformbare Material eine strukturierte Oberfläche zum In-Kontakt-Bringen des PUT-Kopfs beinhaltet und konfiguriert, um die Haftung und/oder Lösung des Halbleiterchips zu erleichtern.

20. Verfahren gemäß Anspruch 19, wobei die strukturierte Oberfläche längliche Stützen beinhaltet, die sich von der strukturierten Oberfläche erstrecken

## Revendications

1. Un procédé pour la fabrication d'un élément d'écran (400, 1600) comprenant une pluralité de pixels (1622b), chaque pixel (1622b) comprenant une pluralité de sous-pixels (1624b), chaque sous-pixel (1624b) étant configuré pour fournir de la lumière d'une longueur d'onde donnée, le procédé comprenant :
l'engagement, en utilisant un outil de préhension (Pick Up Tool, PUT), d'un premier cycle de placement (1908) comprenant la préhension d'une pluralité de premières puces à diodes électroluminescentes (LED) non contrôlées (200, 300, 402), chaque première puce LED comprenant au moins un premier émetteur LED configuré pour fournir un sous-pixel de la pluralité de sous-pixels (1624b) de l'écran (400, 1600), et le placement des premières puces LED (200, 300, 402) sur un substrat d'écran (512) à des emplacements (1622a) correspondant à la pluralité de pixels (1622b) de l'écran (400, 1600) ;
le fait de contrôler les premiers émetteurs LED sur le substrat d'écran (512) afin de déterminer un ou plusieurs emplacements de premiers émetteurs LED non fonctionnels ;
le fait de contrôler une pluralité de deuxièmes puces LED, chacune comprenant au moins un deuxième émetteur LED configuré pour fournir un sous-pixel de la pluralité de sous-pixels de l'écran afin de déterminer la pluralité de deuxièmes puces LED comme puces réputées bonnes ;
parmi la pluralité de deuxièmes puces LED, la sélection d'une ou de plusieurs deuxièmes puces LED sur la base d'un résultat du contrôle des premiers émetteurs LED;
la configuration des une ou plusieurs puces LED sélectionnées afin de permettre leur préhension et leur placement sur le substrat d'écran ; et
l'engagement, en utilisant le PUT, d'un deuxième cycle de placement (2008) comprenant la préhension des une ou plusieurs deuxièmes puces LED sélectionnées et le placement des une ou plusieurs deuxièmes puces LED sélectionnées sur le substrat d'écran (512) aux emplacements déterminés des premiers émetteurs LED non fonctionnels.

2. Le procédé selon la revendication 1, où la configuration des une ou plusieurs deuxièmes puces LED sélectionnées comprend le dépôt d'un matériau déformable sur les une ou plusieurs deuxièmes puces LED sélectionnées ;
facultativement, où le matériau déformable est configuré pour provoquer une adhésion entre les une ou plusieurs deuxièmes puces LED sélectionnées et le PUT pendant le deuxième cycle de placement (2008).

3. Le procédé selon la revendication 2, où le dépôt du matériau déformable sur les une ou plusieurs deuxièmes puces LED sélectionnées comprend l'application du matériau déformable sur un moule ou un porteur et la mise en prise du moule ou du porteur avec une surface d'une ou de plusieurs des deuxièmes puces LED sélectionnées de sorte que le matériau déformable soit en contact avec la surface des une ou plusieurs des deuxièmes puces LED sélectionnées ;
facultativement, où le dépôt du matériau déformable sur les une ou plusieurs deuxièmes puces LED sélectionnées comprend la modification d'un niveau d'adhésion entre le matériau déformable et les une ou plusieurs deuxièmes puces LED sélectionnées de sorte que le matériau déformable adhère aux une ou plusieurs deuxièmes puces LED sélectionnées ;
où la modification du niveau d'adhésion entre le matériau déformable et les une ou plusieurs deuxièmes puces LED sélectionnées comprend facultativement l'exposition à de la lumière d'une ou de plusieurs portions du moule ou de l'élément porteur correspondant à des emplacements des une ou plusieurs deuxièmes puces LED sélectionnées ;
où la lumière comprend facultativement de la lumière ultraviolette.

4. Le procédé selon la revendication 2 ou la revendication 3, où avant le dépôt de la couche déformable sur les une ou plusieurs deuxièmes puces LED sélectionnées, le procédé comprend le placement des une ou plusieurs deuxièmes puces LED sélectionnées sur une couche de manipulation ;
facultativement, où on fait adhérer les une ou plusieurs deuxièmes puces LED sélectionnées à la couche de manipulation.

5. Le procédé selon n'importe quelle revendication précédente, où le deuxième cycle de placement (2008) comprend la modification d'un niveau d'adhésion entre les une ou plusieurs deuxièmes puces LED et la couche de manipulation (906), de telle sorte que le niveau d'adhésion est inférieur à une force appliquée par le PUT.

6. Le procédé selon n'importe quelle revendication précédente, le procédé comprenant le dépôt d'un matériau déformable sur la pluralité de premières puces LED (200, 300, 402), avant l'engagement du premier cycle de placement (1908) ;
facultativement, où le matériau déformable est configuré pour provoquer une adhésion entre la pluralité de premières puces LED et le PUT pendant le premier cycle de placement (1908).

7. Le procédé selon n'importe quelle revendication précédente, comprenant en outre l'engagement d'un contrôle supplémentaire des premiers émetteurs LED et/ou des deuxièmes émetteurs LED après le deuxième cycle de placement (2008) afin de déterminer des emplacements d'un ou de plusieurs premiers et/ou deuxièmes émetteurs LED non fonctionnels ;
facultativement, comprenant en outre la sélection d'une ou de plusieurs troisièmes puces LED contrôlées après l'engagement du contrôle supplémentaire, sur la base d'un résultat du contrôle supplémentaire.

8. Le procédé selon la revendication 7, où le contrôle et/ou le contrôle supplémentaire comprend l'application d'une polarité inverse aux premiers et/ou aux deuxièmes émetteurs LED et/ou l'application d'une polarité directe aux premiers et/ou deuxièmes émetteurs et l'utilisation d'un ou de plusieurs filtre(s) afin d'analyser l'émission des premiers et/ou deuxièmes émetteurs LED.

9. Le procédé selon la revendication 7 ou la revendication 8, comprenant en outre l'engagement d'un ou de plusieurs cycles d'étalonnage d'un écran assemblé sur la base des résultats du contrôle et/ou du contrôle supplémentaire ;
facultativement, où les un ou plusieurs cycles d'étalonnage comprennent la déconnexion d'un ou de plusieurs premiers et/ou deuxièmes émetteurs LED non fonctionnels d'une circuiterie d'attaque sur le substrat d'écran (512).

10. Le procédé selon n'importe quelle revendication précédente, comprenant en outre le dépôt d'un matériau de sous-remplissage (underfill) ou d'un film non conducteur sur le substrat d'écran (512), avant les premier et/ou deuxième cycles de placement (1908, 2008) ;
facultativement, comprenant en outre la modification d'une viscosité du matériau de sous-remplissage ou film non conducteur afin de permettre le pré-collage ou le collage des premières puces LED (200, 200, 402) et des une ou plusieurs deuxièmes puces LED sélectionnées sur le substrat d'écran (512).

11. Le procédé selon n'importe quelle revendication précédente, où les premières et/ou deuxièmes puces LED comprennent un élément de collage agencé pour permettre une interconnexion des premières et/ou deuxièmes puces LED au substrat d'écran (512) ; facultativement, où l'élément de collage est configuré pour former un contact temporaire avec un contact électrique du substrat d'écran (512), autorisant de ce fait le contrôle des premières et/ou deuxièmes puces LED.

12. Le procédé selon n'importe quelle revendication précédente, comprenant en outre le collage des premières puces LED et/ou des unes ou plusieurs deuxièmes puces LED sélectionnées au substrat d'écran (512) en utilisant une tête de collage (2330) ; facultativement, où la tête de collage (2330) comprend un tambour configuré pour se déplacer sur l'ensemble du substrat d'écran (512) de l'écran (400, 1600) et appliquer une force sur les premières puces LED et/ou les une ou plusieurs deuxièmes puces LED sélectionnées positionnées sur celui-ci.

13. Le procédé selon n'importe quelle revendication précédente, où le PUT est un PUT non sélectif ; et/ou
où les premières et deuxièmes puces LED comprennent des puces micro-LED (µLED) comprenant un ou plusieurs émetteurs µLED respectifs ;
facultativement, où chaque émetteur µLED comprend des première et deuxième électrodes configurées pour autoriser un courant à passer par l'émetteur µLED, et où les première et deuxième électrodes sont positionnées sur la même surface de la puce µLED ;
où les première et deuxième électrodes sont facultativement positionnées sur une surface de la puce µLED à l'opposé d'une surface d'émission ;
facultativement, où les puces µLED comprennent une pluralité d'émetteurs µLED, chacun configuré pour émettre de la lumière de substantiellement la même longueur d'onde ;
où une électrode des premières et deuxièmes électrodes est facultativement commune à chaque émetteur de la pluralité d'émetteurs µLED.

14. Un programme d'ordinateur comprenant des instructions qui, lorsqu'elles sont exécutées sur au moins un processeur, amènent l'au moins un processeur à mettre en œuvre le procédé selon l'une quelconque des revendications des revendications 1 à 13 ou 16 à 18 ou 19.

15. Un porteur contenant le programme d'ordinateur de la revendication 14, le porteur étant un porteur parmi un signal électronique, un signal optique, un signal radio ou un support de stockage non transitoire lisible par ordinateur.

16. Le procédé selon la revendication 2 ou la revendication 6, où le matériau déformable comprend un matériau élastique ;
facultativement, où le matériau élastique comprend un matériau élastomère.

17. Un procédé selon la revendication 16, où le contact entre la tête PUT et le matériau déformable résulte en l'absence substantielle de vides entre ceux-ci ; et/ou facultativement, comprenant en outre le dépôt du matériau déformable sur une surface de la pastille de semi-conducteur ; et/ou
facultativement, comprenant en outre le fait d'éliminer le matériau déformable de la surface de la pastille de semi-conducteur ;
facultativement, où l'élimination du matériau déformable se fait par un processus de gravure ; et/ou
où le matériau déformable est facultativement déposé sur le dessus d'une couche sacrificielle déposée sur la surface de la pastille de semi-conducteur, et où le processus de gravure enlève par gravure la couche sacrificielle.

18. Un procédé selon la revendication 16 ou la revendication 17, où la tête PUT est substantiellement rigide et/ou substantiellement plane ; et/ou comprenant en outre le fait de faire adhérer sélectivement la tête à une ou plusieurs pastilles d'une pluralité de pastilles de semi-conducteurs ; et/ou où il y a une pluralité de pastilles de semi-conducteurs, le procédé comprenant en outre le fait d'éliminer sélectivement le matériau déformable d'une ou de plusieurs pastilles de semi-conducteurs avant contact avec la tête PUT de telle sorte que la tête PUT n'adhère pas à ces pastilles de semi-conducteurs ; et/ou
comprenant en outre le fait de faire adhérer la tête PUT à une pluralité de pastilles de semi-conducteurs ; et/ou
facultativement, où les pastilles de semi-conducteurs comprennent des pastilles à diodes électroluminescentes inorganiques (ILED) et/ou à micro-LED (µLED) ; facultativement, où le deuxième emplacement est un substrat d'un dispositif à semi-condducteurs ;
où le substrat comprend facultativement un panneau de transistors à films minces en verre ou en plastique ; et
facultativement, comprenant en outre l'agencement d'une pluralité de pastilles ILED et/ou µLED sur le substrat afin de former un générateur d'images d'un écran.

19. Le procédé selon la revendication 1, où :
la configuration des une ou plusieurs deuxièmes puces LED sélectionnées comprend le dépôt d'un matériau déformable sur les une ou plusieurs deuxièmes puces LED sélectionnées ; et
le matériau déformable comprend une surface structurée pour la mise en contact de la tête PUT et configurée pour aider à l'adhésion et/ou au décollement de la pastille de semi-conducteur.

20. Le procédé selon la revendication 19, où la surface structurée comprend des piliers allongés s'étendant à partir de la surface structurée.
